# EUROPEAN PATENT APPLICATION

(11) **EP 4 763 888 A1**
(43) Date of publication of application: **24.06.2026**
(21) Application number: 25217218.4
(22) Date of filing: 20.11.2025
(51) Int. Cl.: C08G 73/10, C08G 73/12, C08L 79/08

(54) **CURABLE RESIN COMPOSITION FOR SOLDER RESIST USE**

(30) Priority: 17.12.2024 JP 2024220848
(71) Applicant: SHIN-ETSU CHEMICAL CO., LTD., Tokyo (JP)
(72) Inventor: Kudo, Yuki, Annaka-shi, 3790224 (JP); Tsutsumi, Yoshihiro, Annaka-shi, 3790224 (JP)
(74) Representative: Angerhausen, Christoph

(57) **Abstract**

Provided is a curable resin composition for solder resist use containing:
(A) a bismaleimide compound represented by formula (1) defined as 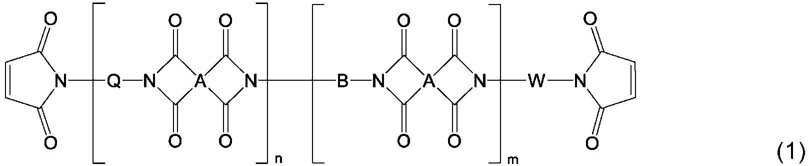 wherein, in the formula (1), each A independently represents a tetravalent organic group having a cyclic structure, each B independently represents a divalent hydrocarbon group derived from a dimer acid skeleton, each Q independently represents a divalent hydrocarbon group having an alicyclic structure or a divalent hydrocarbon group having an aromatic ring, W is B or Q, n is a number of 1 to 100, m is a number of 1 to 100, and repeating units in square brackets with subscripts n and m are arranged in any order;
(B) a citraconimide compound;
(C) an epoxy resin;
(D) a curing accelerator; and
(E) an inorganic filler.

## Description

### BACKGROUND OF THE INVENTION

### Field of the Invention

The present invention relates to a curable resin composition for solder resist use.

### Background art

In recent years, in mobile communication devices typified by mobile phones, base station apparatuses therefor, network infrastructure devices such as servers and routers, and electronic devices such as large-scale computers, the speed and capacity of the signals used are increasing year after year. Accordingly, since high frequencies are used for the printed-wiring boards installed in these electronic devices, insulating materials for the printed wiring boards are required to have characteristics such as a low relative dielectric constant and a low dielectric loss tangent. Examples the materials that can meet these characteristics include epoxy resins, modified polyphenylene ether resins, and maleimide resins (JP-A-2019-1965, JP-A-2018-28044, JP-A-2020-176190, and JP-A-2021-181531).

The solder resist is a material that forms a resin layer on a printed wiring board having a conductive pattern formed thereon and is used to coat and protect the wiring circuit so that, when electronic components are soldered, the solder is prevented from adhering to areas not to be covered with the solder. A resin composition used for the solder resist is required to have printability, a high glass transition temperature, a low coefficient of thermal expansion, good adhesiveness, solder heat resistance, etc. Moreover, in addition to these characteristics, a low relative dielectric constant and a low dielectric loss tangent are required due to the recent increase in the communication speed.

In many conventional resin compositions for solder resist use, an epoxy resin and a resin having an acrylate group and a carboxy group are used as main components. In particular, a photosensitive solder resist is generally developed using an alkali aqueous solution, and the photosensitive solder resist composition must contain a carboxy group (JP-A-2007-199491, JP-A-2016-136248, JP-A-2019-174788, and JP-A-2021-91879). To obtain a final cured film of the photosensitive solder resist, the photosensitive solder resist is applied to a substrate, exposed to light, and developed to form a pattern, and then carboxy groups and epoxy groups in the resin are thermally cured. However, even after the reaction, carboxy groups and hydroxy groups still remain in the solder resist, and therefore the dielectric loss in a high frequency band is large, so that the waveforms of signals are disturbed. Another problem in this case is that heat is generated during use. Considering these factors, it is difficult to achieve a resin composition for solder resist use having a low relative dielectric constant and a low dielectric loss tangent using conventional materials, and there is a need for the development of novel materials.

For example, JP-A-2023-144570 discloses, as a novel material meeting these requirements, a thermosetting resin composition containing bismaleimide having a dimer acid skeleton and a trifunctional epoxy compound. It is stated that a solder resist film formed of the thermosetting resin composition has a low relative dielectric constant and a low dielectric loss tangent. However, in the thermosetting resin composition disclosed in JP-A-2023-144570, the glass transition temperature tends to be low, and there is still room for improvement.

### SUMMARY OF THE INVENTION

Accordingly, it is an object of the invention to provide a curable resin composition for solder resist use having good screen printability and capable of forming a cured product having a high glass transition temperature, a low coefficient of thermal expansion, high solder heat resistance, good adhesion to copper foil, a low relative dielectric constant, and a low dielectric loss tangent. Therefore, the curable resin composition of the invention can be preferably used for solder resists.

The present inventors have conducted extensive studies to solve the foregoing problems and found that the above object can be achieved by the following curable resin composition. Thus, the invention has been completed.

Accordingly, the present invention provides the following curable resin composition for solder resist use.
<1> A curable resin composition for solder resist use, comprising: (A) a bismaleimide compound represented by formula (1) defined as 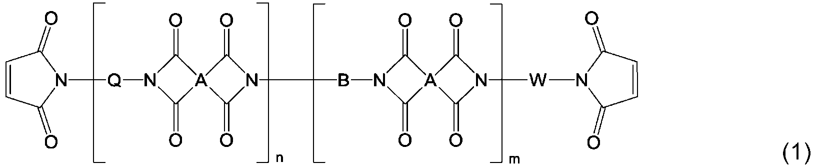 wherein, in the formula (1), each A independently represents a tetravalent organic group having a cyclic structure, each B independently represents a divalent hydrocarbon group derived from a dimer acid skeleton, each Q independently represents a divalent hydrocarbon group having an alicyclic structure or a divalent hydrocarbon group having an aromatic ring, W is B or Q, n is a number of 1 to 100, m is a number of 1 to 100, and repeating units in square brackets with subscripts n and m are arranged in any order;
   (B) a citraconimide compound;
   (C) an epoxy resin;
   (D) a curing accelerator; and
   (E) an inorganic filler.
<2> The curable resin composition for solder resist use according to <1>, further comprising (F) an organic solvent.
<3> The curable resin composition for solder resist use according to <2>, wherein the organic solvent (F) has a boiling point of 200°C or higher.
<4> The curable resin composition for solder resist use according to any one of <1> to <3>, wherein Q in the formula (1) is a divalent group having an alicyclic skeleton, a fluorene skeleton, or an indene skeleton represented by any of the following formulas (2-1), (2-2), and (2-3): 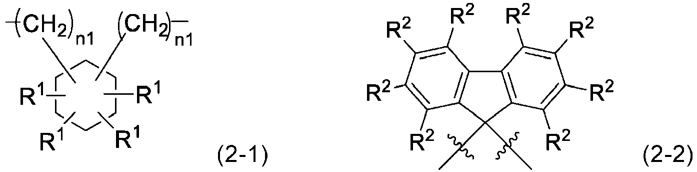 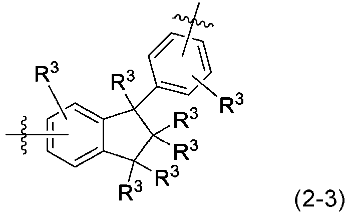 wherein each R¹ independently represents a hydrogen atom or an alkyl group having 1 to 5 carbon atoms, each n1 independently represents an integer of from 0 to 4, each R² and each R³ independently represent a hydrogen atom, an alkyl group having 1 to 5 carbon atoms, a (hetero)aryl group having 4 to 10 carbon atoms, a hydroxy group, an organooxy group, a halogeno group, a trifluoromethyl group, an amino group, or a sulfenyl group.
<5> The curable resin composition for solder resist use according to any one of <1> to <4>, wherein A in the formula (1) is a tetravalent organic group represented by any of the following formulas: 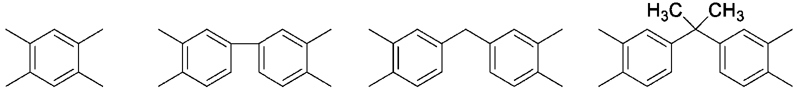 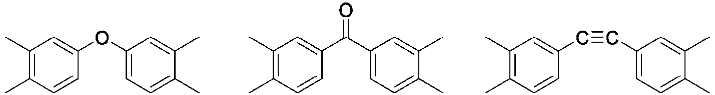 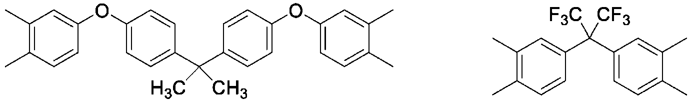 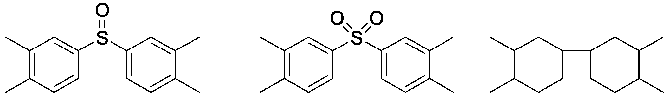 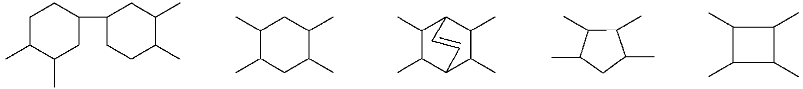 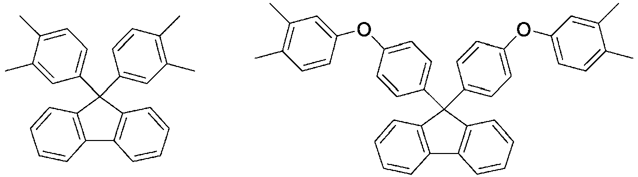 wherein, in the above formulas, each bond with no substituent bonded thereto is bonded to carbonyl carbon included in a cyclic imide structure in the formula (1).
<6> The curable resin composition for solder resist use according to any one of <1> to <5>, wherein the bismaleimide compound represented by the formula (1) has a number average molecular weight of 3,000 to 50,000.
<7> The curable resin composition for solder resist use according to any one of <1> to <6>, wherein the citraconimide compound (B) is a biscitraconimide compound represented by formula (3) defined as: 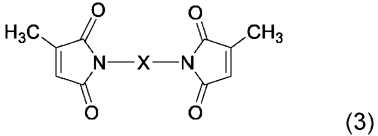 wherein, in the formula (3), X is a divalent organic group.
<8> The curable resin composition for solder resist use according to <7>, wherein X in the formula (3) is selected from a hydrocarbon group derived from a dimer acid skeleton and groups represented by the following structures: 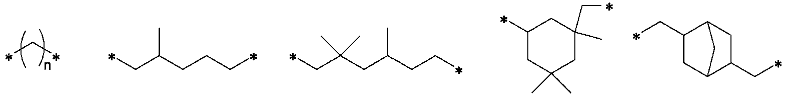 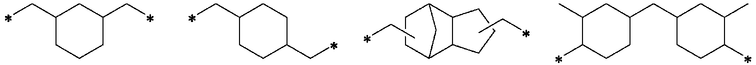 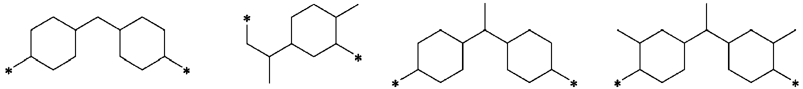 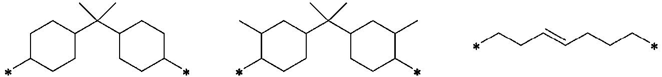 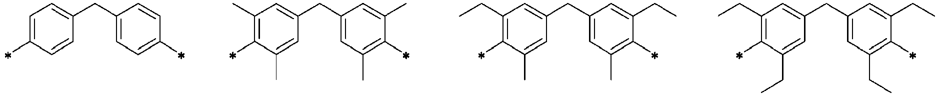 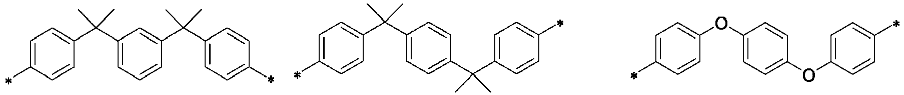 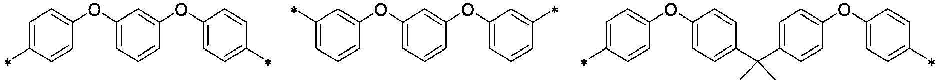 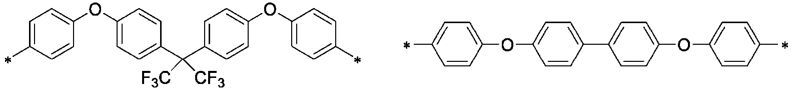 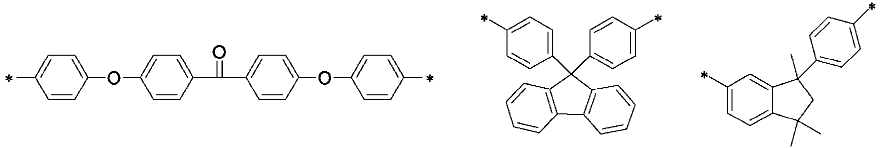 wherein * represents a bond to a nitrogen atom in a citraconimide group, and n is a number of 1 to 20.
<9> The curable resin composition for solder resist use according to any one of <1> to <8>, wherein the citraconimide compound (B) has a number average molecular weight of 100 to 5,000.
<10> The curable resin composition for solder resist use according to any one of <1> to <9>, wherein the epoxy resin (C) is liquid at 25°C.

### DETAILED DESCRIPTION OF THE INVENTION

The present invention will next be described in detail.

A component (A) used in the invention is a bismaleimide compound represented by the following formula (1):

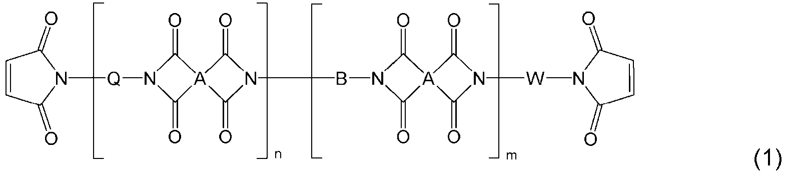

In the formula (1), each A independently represents a tetravalent organic group having a cyclic structure. Each B independently represents a divalent hydrocarbon group derived from a dimer acid skeleton. Each Q independently represents a divalent hydrocarbon group having an alicyclic structure or a divalent hydrocarbon group having an aromatic ring. W is B or Q. n is a number of 1 to 100, and m is a number of 1 to 100. Repeating units in square brackets with subscripts n and m are arranged in any order. Specifically, no limitation is imposed on the order of the repeating units, and the repeating units may be bonded in an alternate manner, a block manner, or a random manner.

In the formula (1), each Q independently represents a divalent hydrocarbon group having an alicyclic structure or a divalent hydrocarbon group having an aromatic ring. Preferably, each Q independently represents a divalent group having an alicyclic skeleton, a fluorene skeleton, or an indene skeleton represented by any of formulas (2-1), (2-2), and (2-3) below.

The bismaleimide compound used as the component (A) has a divalent hydrocarbon group derived from a dimer acid skeleton in its molecule and has an alicyclic skeleton, a fluorene skeleton, or an indene skeleton. Therefore, a cured product of the resin composition containing the bismaleimide compound (A) has good dielectric characteristics and high heat resistance.

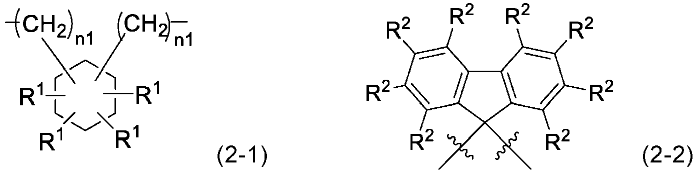

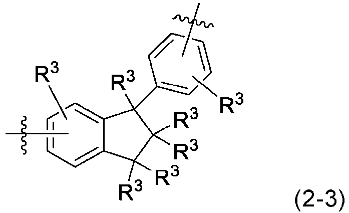

In the above formulas, each R¹ independently represents a hydrogen atom or an alkyl group having 1 to 5 carbon atoms, and each n1 independently represents a number of 0 to 4. Each R² and each R³ independently represent a hydrogen atom, an alkyl group having 1 to 5 carbon atoms, a (hetero)aryl group having 4 to 10 carbon atoms, a hydroxy group, an alkoxy group, a halogeno group, a trifluoromethyl group, an amino group, or a sulfenyl group.

In the structural formulas represented by the formulas (2-1), (2-2), and (2-3), each bond with no substituent bonded thereto may be bonded directly or via a divalent group to a nitrogen atom included in a cyclic imide structure in the formula (1). The hydrocarbon group represented by Q may contain a halogen atom or a hetero atom-containing group such as an ester group, an ether group, or an amide group as a substituent, an interrupting group, etc. so long as the basic skeleton of the hydrocarbon group is a hydrocarbon structure, particularly an alicyclic structure or an aromatic ring.

In the formula (2-1), each R¹ independently represents a hydrogen atom or an alkyl group having 1 to 5 carbon atoms, and each n1 independently represents a number of 0 to 4. In the formula (2-1), each R¹ independently represents a hydrogen atom, a methyl group, an ethyl group, a n-propyl group, an isopropyl group, a n-butyl group, an isobutyl group, or a t-butyl group. Of these, a hydrogen atom and a methyl group are preferred. R¹'s may all be the same or different. Each n1 independently represents a number of 0 to 4 and preferably a number of 0 to 2. n1's may all be the same or different.

Specific examples of Q having the alicyclic skeleton represented by the formula (2-1) include the following structural formulas:

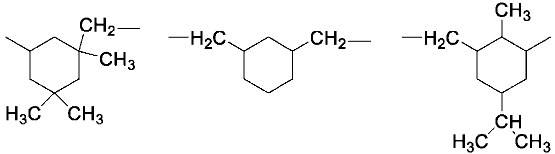

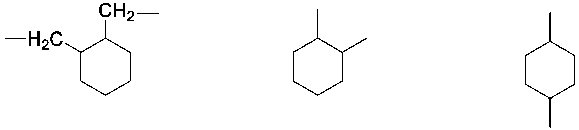

In the above structural formulas, each bond with no substituent bonded thereto is bonded to a nitrogen atom included in a cyclic imide structure in the formula (1).

In the formula (2-2), each R² independently represents a hydrogen atom, an alkyl group having 1 to 5 carbon atoms, a (hetero)aryl group having 4 to 10 carbon atoms, a hydroxy group, an organooxy group, a halogeno group, a trifluoromethyl group, an amino group, or a sulfenyl group.

Examples of the alkyl group having 1 to 5 carbon atoms include a methyl group, an ethyl group, a n-propyl group, an isopropyl group, an n-butyl group, a sec-butyl group, an isobutyl group, a tert-butyl group, and a pentyl group.

Examples of the (hetero)aryl group having 4 to 10 carbon atoms include: aryl groups having 6 to 10 carbon atoms such as a phenyl group, a tolyl group, a xylyl group, and a naphthyl group; and heteroaryl groups having 4 to 10 carbon atoms such as a furyl group, a thienyl group, a pyridyl group, and an indolyl group.

Examples of the organooxy group include a methoxy group, an ethoxy group, a n-propyloxy group, an isopropyloxy group, a n-butyloxy group, an isobutyloxy group, a t-butyloxy group, a n-pentyloxy group, an isopentyloxy group, a hexyloxy group, a benzyloxy group, a phenethyloxy group, an allyloxy group, a phenyloxy group, a tolyloxy group, a xylyloxy group, a naphthyloxy group, a furyloxy group, a thienyloxy group, a pyridyloxy group, and an indolyloxy group.

Examples of the halogeno group include fluoro groups, chloro groups, bromo groups, and iodo groups.

Each R² is preferably a hydrogen atom, and specific examples of Q having the fluorene skeleton represented by the formula (2-2) include the following structural formulas:

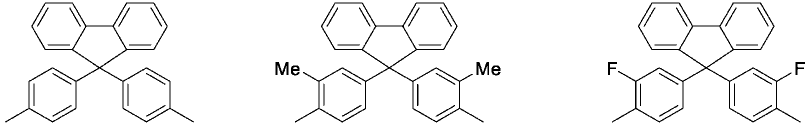

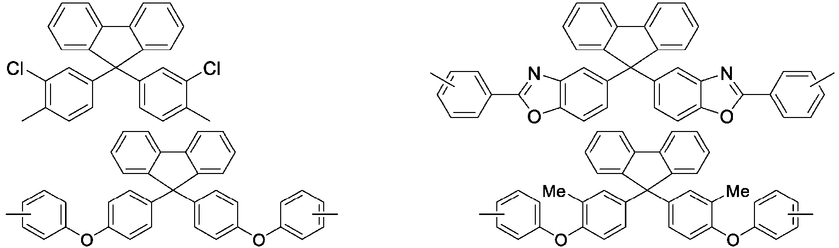

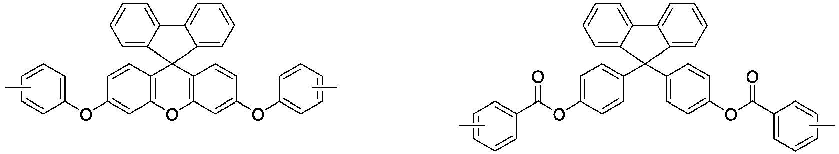

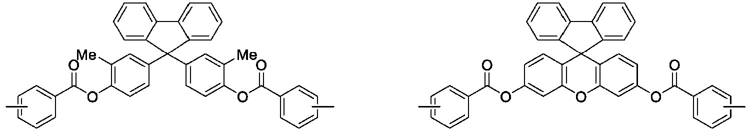

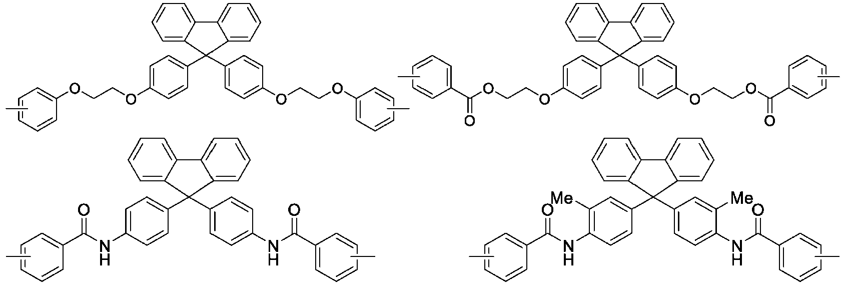

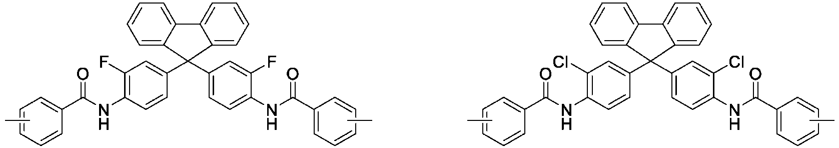

In the above structural formulas, each bond with no substituent bonded thereto is bonded to a nitrogen atom included in a cyclic imide structure in the formula (1).

Q having the fluorene skeleton represented by the formula (2-2) is particularly preferably any of the groups represented by the following structural formulas.

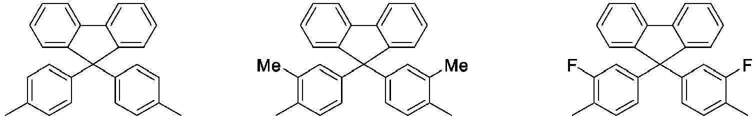

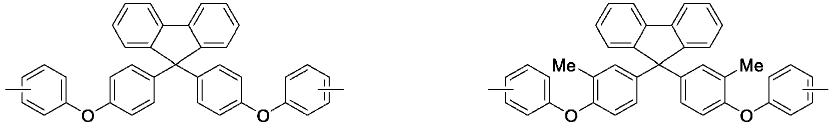

In the formula (2-3), each R³ independently represents a hydrogen atom, an alkyl group having 1 to 5 carbon atoms, a (hetero)aryl group having 4 to 10 carbon atoms, a hydroxy group, an alkoxy group, a halogeno group, a trifluoromethyl group, an amino group, or a sulfenyl group.

Examples of the alkyl group having 1 to 5 carbon atoms include a methyl group, an ethyl group, a n-propyl group, an isopropyl group, a n-butyl group, a sec-butyl group, an isobutyl group, a tert-butyl group, and a pentyl group.

Examples of the (hetero)aryl group having 4 to 10 carbon atoms include: aryl groups having 6 to 10 carbon atoms such as a phenyl group, a tolyl group, a xylyl group, and a naphthyl group; and heteroaryl groups having 4 to 10 carbon atoms such as a furyl group, a thienyl group, a pyridyl group, and an indolyl group.

Examples of the alkoxy group include a methoxy group, an ethoxy group, a n-propyloxy group, an isopropyloxy group, a n-butyloxy group, an isobutyloxy group, a t-butyloxy group, a n-pentyloxy group, an isopentyloxy group, a hexyloxy group, a benzyloxy group, a phenethyloxy, group, an allyloxy group, a phenyloxy group, a tolyloxy group, a xylyloxy group, a naphthyloxy group, a furyloxy group, a thienyloxy group, a pyridyloxy group, and an indolyloxy group.

Examples of the halogeno group include fluoro groups, chloro groups, bromo groups, and iodo groups.

Each R³ in the formula (2-3) is preferably a hydrogen atom or an alkyl group having 1 to 5 carbon atoms and particularly preferably a hydrogen atom or a methyl group. Specific examples of Q having the indene skeleton represented by the formula (2-3) include the following structural formulas:

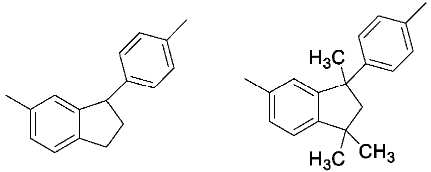

In the above structural formulas, each bond with no substituent bonded thereto is bonded to a nitrogen atom included in a cyclic imide structure in the formula (1).

The aromatic ring-containing divalent group represented by Q is a group derived from, for example, an aromatic ring-containing diamine in a production method described later. Examples of the aromatic ring-containing diamine include 9,9-bis(4-aminophenyl)fluorene (hereinafter referred to also as FDA), 9,9-bis(4-amino-3-methylphenyl)fluorene, 9,9-bis(4-amino-3-fluorophenyl)fluorene (hereinafter referred to also as FFDA), 9,9-bis(4-amino-3-chlorophenyl)fluorene, 9,9-bis(4-amino-3-hydroxyphenyl)fluorene, 9,9-bis[4-(4-aminophenoxy)phenyl] fluorene, 1-(4-aminophenyl)-2,3-dihydro-1,3,3-trimethyl-1H-indene-5-amine (hereinafter referred to also as PIDA), 3-(4-aminophenyl)-2,3-dihydro-3-methyl-1,1-diphenyl-1H-indene-5-amine, 2-(4-aminophenyl)-1-ethyl-2,3-dihydro-3-methyl-1H-indene-5-amine, and 1,3,3-tris(4-aminophenyl)-2,3-dihydro-1-methyl-1H-indene-5-amine. One of these diamines may be used alone, or a combination of two or more may be used, according to the intended application. The aromatic ring-containing diamine is preferably FDA, FFDA, or PIDA because the resin composition containing the bismaleimide compound represented by the formula (1) can have good dielectric characteristics, a high glass transition temperature, and a low coefficient of thermal expansion.

In the formula (1), each A independently represents a tetravalent organic group having a cyclic structure and may be a group derived from a tetracarboxylic dianhydride monomer and having a fluorene skeleton or having no fluorene skeleton. Examples of the tetracarboxylic dianhydride monomer include pyromellitic dianhydride, 4,4'-carbonyldiphthalic dianhydride, 4,4'-oxydiphthalic dianhydride, 3,4'-oxydiphthalic anhydride, 4,4'-biphthalic dianhydride, 4,4'-(4,4'-isopropylidenediphenoxy)diphthalic dianhydride, 1,2,3,4-cyclobutanetetracarboxylic dianhydride, 1,2,4,5-cyclohexanetetracarboxylic dianhydride, 1,2,3,4-cyclopentanetetracarboxylic dianhydride, 9,9-bis(3,4-dicarboxyphenyl)fluorene dianhydride, 9,9-bis[4-(3,4-dicarboxyphenoxy)phenyl]fluorene dianhydride, 4,4'-(hexafluoroisopropylidene)diphthalic dianhydride, dicyclohexyl-3,4,3',4'-tetracarboxylic dianhydride, norbornane-2-spiro-α-cyclopentanone-α'-spiro-2"-norbornane-5,5",6,6"-tetracarboxylic dianhydride, 3,3',4,4'-benzophenonetetracarboxylic dianhydride, 4,4'-(ethyne-1,2-diyl)diphthalic dianhydride, 3-(carboxymethyl)-1,2,4-cyclopentanetricarboxylic acid 1,4:2,3-dianhydride, 2,3,6,7-naphthalenetetracarboxylic acid 2,3:6,7-dianhydride, naphthalene-1,4,5,8-tetracarboxylic dianhydride, bis(1,3-dioxo-1,3-dihydroisobenzofuran-5-carboxylic acid)1,4-phenylene, and 3,4,9,10-perylenetetracarboxylic dianhydride. One of these acid anhydrides may be used alone, or a combination of two or more may be used, according to the intended application etc.

Specific examples of the tetravalent organic group A in the formula (1) include the following structural formulas:

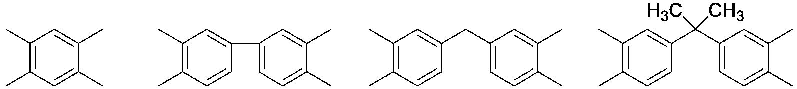

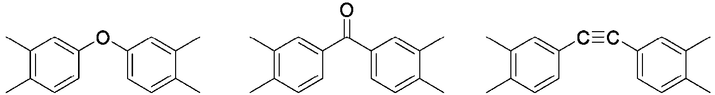

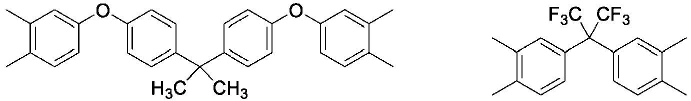

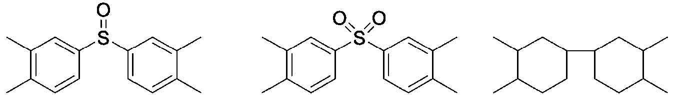

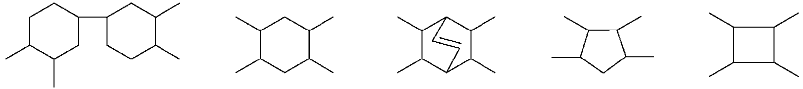

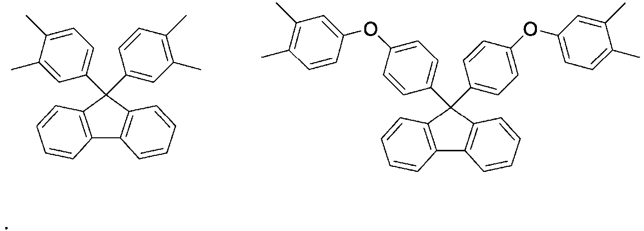

In the above formulas, each bond with no substituent bonded thereto is bonded to carbonyl carbon included in a cyclic imide structure in the formula (1).

The tetracarboxylic dianhydride monomer is preferably 4,4'-(4,4'-isopropylidenediphenoxy)diphthalic dianhydride because the bismaleimide compound represented by the formula (1) can have good dielectric characteristics and high solubility in solvents.

In the formula (1), each B independently represents at least one divalent hydrocarbon group derived from a dimer acid skeleton. The dimer acid is a liquid dibasic acid that contains a dicarboxylic acid having 36 carbon atoms as a main component and that is obtained by dimerizing an unsaturated fatty acid having 18 carbon atoms using a natural substance such as a vegetable fat or oil as a raw material. The dimer acid skeleton is not a single skeleton and includes a plurality of structures, and there are several types of isomers. Representative dimer acids are classified into (a) linear type, (b) monocyclic type, (c) aromatic ring type, and (d) polycyclic type.

In the present specification, the dimer acid skeleton is a group derived from a dimer diamine having a structure obtained by replacing the carboxy groups in such a dimer acid with primary aminomethyl groups.

Specific examples of the divalent hydrocarbon group B derived from a dimer acid skeleton in the formula (1) include, but are not limited to, branched divalent hydrocarbon groups obtained by replacing two carboxy groups in any of dimer acids represented by the following (a) to (d) with methylene groups.

More preferably, the hydrocarbon group derived from the dimer acid skeleton has a structure in which the number of carbon-carbon double bonds in the hydrocarbon group derived from the dimer acid skeleton has been reduced by a hydrogenation reaction, from the viewpoint of the heat resistance and reliability of the cured product.

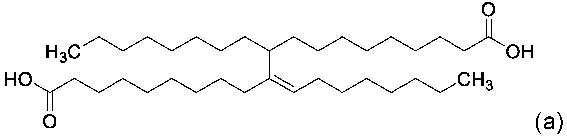

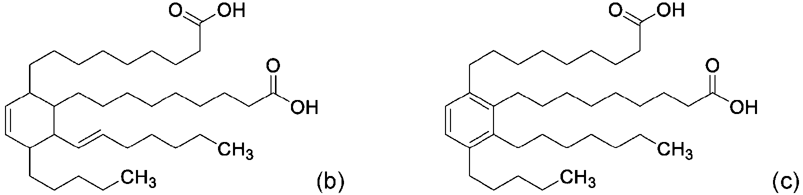

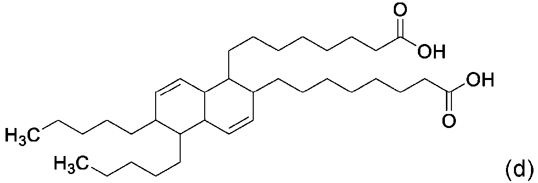

As described above, the dimer acid skeleton has a plurality of structures. Therefore, in the present specification, the divalent hydrocarbon group derived from the dimer acid skeleton may be denoted by -C₃₆H₇₀- representing its average structure.

In the formula (1), W is B or Q. Whether W is B or Q is determined by the difference in production method described later.

In the formula (1), n is 1 to 100, preferably 1 to 50, and more preferably 1 to 10. m is 1 to 100, preferably 1 to 50, and more preferably 1 to 10. If n and m are excessively small, the cured product tends to be brittle and fragile. If n and m are excessively large, the flowability may deteriorate, and the formability may deteriorate.

No particular limitation is imposed on the number average molecular weight (Mn) of the bismaleimide compound in the invention. The number average molecular weight (Mn) is preferably 3,000 to 50,000, more preferably 3,500 to 20,000, and still more preferably 4,000 to 10,000. When the number average molecular weight is within the above range, the viscosity of the resin composition containing the bismaleimide compound in the invention is not excessively high, and the cured product of the resin composition has high strength.

The number average molecular weight (Mn) used in the present specification is a number average molecular weight measured by GPS using polystyrene as a reference material under the following conditions.

### [GPC measurement conditions]

### Eluent: Tetrahydrofuran

### Flow rate: 0.35 mL/min

Columns:
TSKgel guardcolumn Super HZ-L (4.6 mm I.D. × 2 cm × 1)
TSKgel Super H-RC (6.0 mm I.D. × 15 cm × 2)
TSKgel SuperHZ 4000 (4.6 mm I.D. × 15 cm × 1)
TSKgel SuperHZ 3000 (4.6 mm I.D. × 15 cm × 1)
TSKgel SuperHZ 2000 (4.6 mm I.D. × 15 cm × 2)
(all manufactured by TOSOH Corporation)

### Column temperature: 40°C

Sample injection volume: 10 µL (sample concentration: 0.2% by mass - tetrahydrofuran solution)

### Detector: Differential refractometer (RI)

In the bismaleimide compound represented by the formula (1) in the invention, repeating units in square brackets with subscripts n and m in the formula are arranged in any order. Specifically, no limitation is imposed on the order of the repeating units, and the repeating units may be bonded in an alternate manner, a block manner, or a random manner. Preferably, the repeating units are bonded in a block manner.

No particular limitation is imposed on the method for producing the bismaleimide compound used as the component (A). For example, the bismaleimide compound can be effectively produced using either of the following two methods.

### Production method 1

A first bismaleimide compound production method includes:
Step A of synthesizing
   an amic acid using an acid anhydride represented by the following formula (4): 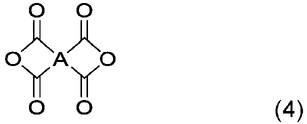 wherein, in the formula (4), A is the same as that in the formula (1), and
   an alicyclic structure- or aromatic ring-containing diamine represented by the following formula (5):

      H₂N-Q-NH₂ (5)

      wherein, in the formula (5), Q is the same as that in the formula (1), and
      subjecting the amic acid to cyclodehydration;
Step B performed after the step A and including synthesizing an amic acid using the reaction product obtained in the step A and a diamine derived from a dimer acid skeleton and represented by the following formula (6):

   H₂N-B-NH₂ (6)

   wherein, in the formula (6), B is the same as that in the formula (1), and subjecting the amic acid to cyclodehydration; and
Step C performed after the step B and including synthesizing a maleamic acid using the reaction product obtained in the step B and maleic anhydride and subjecting the maleamic acid to cyclodehydration to thereby cap the molecular chain ends with maleimide groups.

### Production method 2

A second bismaleimide compound production method includes:
Step A' of synthesizing
   an amic acid using an acid anhydride represented by the following formula (4): 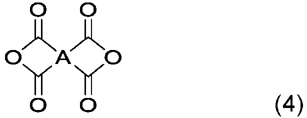 wherein, in the formula (4), A is the same as that in the formula (1); and
   a diamine derived from a dimer acid skeleton and represented by the following formula (6):

      H₂N-B-NH₂ (6)

      wherein, in the formula (6), B is the same as that in the formula (1) and subjecting the amic acid to cyclodehydration;
Step B' performed after the step A' and including synthesizing an amic acid using the reaction product obtained in the step A' and an alicyclic structure- or aromatic ring-containing diamine represented by the following formula (5):

   H₂N-Q-NH₂ (5)

   wherein, in the formula (5), Q is the same as that in the formula (1), and subjecting the amic acid to cyclodehydration; and
Step C' performed after the step B' and including synthesizing a maleamic acid using the reaction product obtained in the step B' and maleic anhydride and subjecting the maleamic acid to cyclodehydration to thereby cap the molecular chain ends with maleimide groups.

The basic flow of the two production methods described above includes the step A (or the step A') of synthesizing an amic acid using tetracarboxylic dianhydride and a diamine and subjecting the amic acid to cyclodehydration, the step B (or the step B') performed after the step A (or the step A') and including adding a diamine different from that in the step A (or the step A') to synthesize an amic acid and subjecting the amic acid to cyclodehydration, and the step C (or the step C') performed after the step B (or the step B') and including reacting the resulting product with maleic anhydride to synthesize a maleamic acid and then subjecting the maleamic acid to cyclodehydration to cap the molecular chain ends with maleimide groups, and the bismaleimide compound can thereby be obtained. The only difference between these two methods is the order of addition of the diamines.

In the above two production methods, the steps can be broadly classified into the synthesis reaction of amic acid or maleamic acid and the cyclodehydration reaction, and these reactions will next be described in detail.

In the step A (or the step A'), first, a specific tetracarboxylic dianhydride and a specific diamine are reacted to synthesize an amic acid. This reaction generally proceeds in an organic solvent (such as a non-polar solvent or a high-boiling point aprotic polar solvent) at room temperature (25°C) to 100°C.

The subsequent cyclodehydration reaction of the amic acid is performed at 100 to 160°C while water produced as a byproduct by a condensation reaction is removed from the system. To facilitate the cyclodehydration reaction, an organic solvent (such as a non-polar solvent or a high-boiling point aprotic polar solvent) or an acid catalyst may be added.

Examples of the organic solvent include toluene, xylene, anisole, biphenyl, naphthalene, N-methyl-2-pyrrolidone (NMP), N,N-dimethylformamide (DMF), dimethyl sulfoxide (DMSO), and dimethylacetamide (DMAC). One of these solvents may be used alone, or a combination or two or more may be used. Of these, aromatic solvents such as toluene, xylene, anisole, biphenyl, and naphthalene are preferred, and toluene, xylene, or anisole is particularly preferred, from the viewpoint of solubility.

Examples of the acid catalyst include sulfuric acid, methanesulfonic acid, p-toluenesulfonic acid, and trifluoromethanesulfonic acid. One of them may be used alone, or a combination of two or more may be used.

The amount of the acid catalyst used with respect to 1 mole of the diamine used as a raw material is preferably 0.1 moles or more and 2.0 moles or less and more preferably 0.2 moles or more and 1.0 moles or less.

The molar ratio of the tetracarboxylic dianhydride to the diamine is preferably tetracarboxylic dianhydride / diamine = 1.01 to 1.99 / 1.0, more preferably tetracarboxylic dianhydride / diamine = 1.01 to 1.80 / 1.0, and still more preferably tetracarboxylic dianhydride / diamine = 1.10 to 1.60 / 1.0. By mixing them in the above ratio, a copolymer having imide groups at both ends can be finally synthesized.

In the step B (or the step B'), first, the copolymer having imide groups at both ends and obtained in the step A (or the step A') is reacted with a specific diamine to synthesize an amic acid. This reaction also generally proceeds in an organic solvent (such as a non-polar solvent or a high-boiling point aprotic polar solvent) at room temperature (25°C) to 100°C.

Similarly, the subsequent cyclodehydration reaction of the amic acid is performed at 100 to 160°C while water produced as a byproduct by a condensation reaction is removed from the system. To facilitate the cyclodehydration reaction, an organic solvent (such as a non-polar solvent or a high-boiling point aprotic polar solvent) or an acid catalyst may be added.

Examples of the organic solvent include toluene, xylene, anisole, biphenyl, naphthalene, N-methyl-2-pyrrolidone (NMP), N,N-dimethylformamide (DMF), dimethyl sulfoxide (DMSO), and dimethylacetamide (DMAC). One of them may be used alone, or a combination of two or more may be used. Of these, aromatic solvents such as toluene, xylene, anisole, biphenyl, and naphthalene are preferred, and toluene, xylene, or anisole is particularly preferred, from the viewpoint of solubility.

Examples of the acid catalyst include sulfuric acid, methanesulfonic acid, p-toluenesulfonic acid, and trifluoromethanesulfonic acid. One of them may be used alone, or a combination of two or more may be used.

The amount of the acid catalyst used with respect to 1 mole of the diamine used as a raw material is preferably 0.1 moles or more and 2.0 moles or less and more preferably 0.2 moles or more and 1.0 moles or less.

The molar ratio of the copolymer having imide groups at both ends to the diamine is preferably 1.0 : 0.01 to 1.0 and more preferably 1.0 : 0.1 to 1.0.

In the step C (or the step C'), the diamine having amino groups at both ends and obtained in the step B (or the step B') is reacted with maleic anhydride at room temperature (25°C) to 100°C to synthesize a maleamic acid. Finally, the maleamic acid is subjected to cyclodehydration at 100 to 160°C while water generated as a byproduct is removed to thereby cap molecular chain ends with maleimide groups, and the intended bismaleimide compound can thereby be obtained.

With these production methods, the obtained bismaleimide compound has a block copolymer structure, and therefore the compatibility of the synthesized resin can be homogenized and improved.

The molar ratio of the diamine having amino groups at both ends to the maleic anhydride is preferably 1.0 : 1.6 to 2.5 and more preferably 1.0 : 1.8 to 2.2.

The catalyst etc. can be washed out from the solution of the bismaleimide compound obtained by any of the above production methods by a well-known method (for example, a method including adding water, alcohol, etc. to the solution, stirring the mixture, and allowing the resulting mixture to stand to separate an organic solvent and an aqueous solution from each other).

The bismaleimide compound obtained by any of the above methods can be collected in the form of varnish or can be purified and isolated as a solid powder by adding a poor solvent to cause the compound to reprecipitate. From the viewpoint of the production cost, it is preferable that the bismaleimide compound obtained by any of the above methods is collected in the form of varnish. In this case, the resin varnish obtained contains the bismaleimide compound and the organic solvent used to produce the bismaleimide compound.

Examples of the solvent for the resin varnish include the same organic solvents that can be used for the production methods. The solvent is preferably an aromatic solvent such as toluene, xylene, anisole, biphenyl, or naphthalene and particularly preferably toluene, xylene, or anisole.

The amount of the component (A) added is preferably 20 to 95% by mass and more preferably 30 to 70% by mass based on 100% by mass of the curable resin composition. When the amount added is within the above range, the cured product obtained has a high glass transition temperature and preferable mechanical strength, and a solder resist produced can have good solder heat resistance, a low dielectric constant, and a low dielectric loss tangent.

### (B) Citraconimide compound

The component (B) used in the invention is a citraconimide compound. The citraconimide group is a group in which one hydrogen atom in a maleimide group is replaced with a methyl group. Because of the effects of the methyl group, the dielectric constant and dielectric loss tangent are lower than those of a maleimide compound having the same skeleton. In addition, the melting point and viscosity are lower, and compatibility with other components is improved. By using the component (B) in combination with the components (A) and (C), the cured product of the composition can have a high glass transition temperature and a low coefficient of thermal expansion.

No particular limitation is imposed on the properties of the citraconimide compound used as the component (B) at room temperature and its number average molecular weight. However, the number average molecular weight is preferably 100 to 5,000, more preferably 200 to 3,000, and still more preferably 200 to 2,000. When the number average molecular weight is within the above range, the viscosity after the addition of the citraconimide compound used as the component (B) does not increase excessively, and the resin composition has good printability.

The citraconimide compound used as the component (B) is preferably a biscitraconimide compound having two citraconimide groups per molecule and particularly preferably a biscitraconimide compound represented by the following formula (3), from the viewpoint of the availability of an amine compound used as a raw material, the solubility of the citraconimide compound in a solvent, and the ease of synthesis.

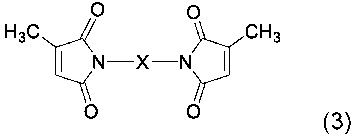

In the formula (3), X represents a divalent organic group.

The divalent organic group represented by X in the citraconimide compound is more preferably selected from groups represented by the following structures in order to obtain low elasticity after curing and good dielectric characteristics (a low relative dielectric constant and a low dielectric loss tangent).

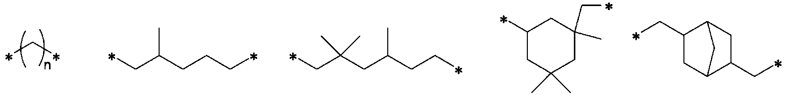

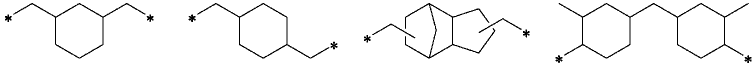

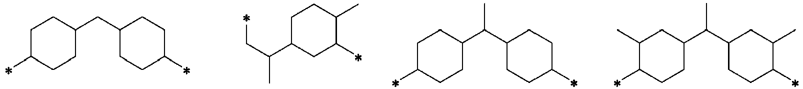

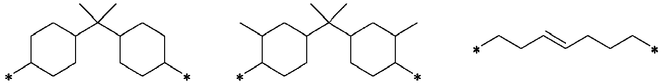

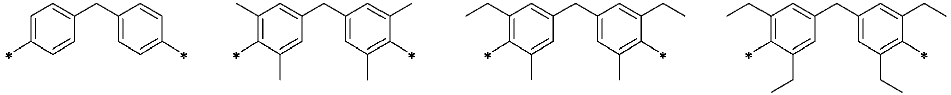

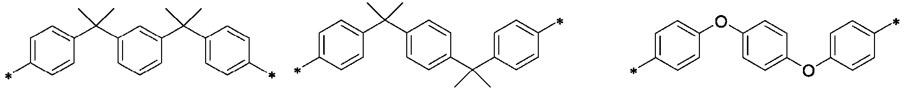

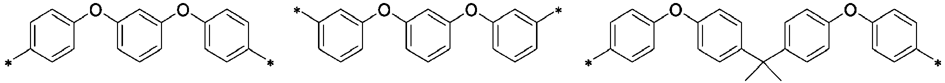

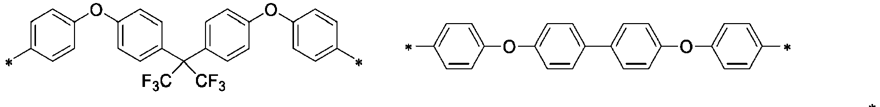

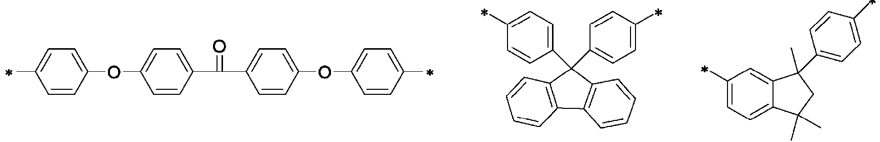

The symbol "*" indicates a bond to the nitrogen atom in a citraconimide group, and n is a number of 1 to 20.

The divalent organic group represented by X is particularly preferably a divalent group derived from 2-methyl-1,5-diaminopentane, 2,2,4-trimethylhexamethylenediamine, 1,3-bis[2-(4-aminophenyl)-2-propyl]benzene, 1,4-bis[2-(4-aminophenyl)-2-propyl)benzene, 2,2-bis[4-(4-aminophenoxy)phenyl]propane, or 2,2-bis[4-(4-aminophenoxy)phenyl]hexafluoropropane, from the viewpoint of the viscosity of the resin composition and the flexibility and dielectric characteristics of the cured product.

One citraconimide compound serving as the component (B) may be used alone, or a combination of two or more may be used.

The amount of the component (B) added in preferably 10 to 100 parts by mass and more preferably 20 to 80 parts by mass based on 100 parts by mass of the component (A). When the amount is within the above range, the viscosity of the resin composition is low. Moreover, the printability of the solder resist to be formed is good, and a low relative dielectric constant and a low dielectric loss tangent are achieved.

### (C) Epoxy resin

The component (C) used in the invention is an epoxy resin. The epoxy resin undergoes an anionic polymerization reaction with the bismaleimide compound used as the component (A) and the citraconimide compound used as the component (B), and a cured product can thereby be obtained. Preferably, the epoxy resin has two or more epoxy groups per molecule, and a well-known epoxy resin can be used. From the viewpoint of handleability, it is preferable that the epoxy resin is liquid at 25°C.

Examples of the epoxy resin include: bisphenol type epoxy resins such as bisphenol A type epoxy resins, bisphenol F type epoxy resins, and bisphenol S type epoxy resins; novolac type epoxy resins such as phenol novolac type epoxy resins, cresol novolac type epoxy resins, bisphenol A novolac type epoxy resins, and bisphenol F novolac type epoxy resins; alicyclic epoxy resins such as dicyclopentadiene type epoxy resins and 3,4-epoxycyclohexenylmethyl-3',4'-epoxycyclohexene carboxylate; polyfunctional phenol type epoxy resins such as resorcinol type epoxy resins and resorcinol novolac type epoxy resins; stilbene type epoxy resins; triazine skeleton-containing epoxy resins; fluorene skeleton-containing epoxy resins; triphenol alkane type epoxy resins; biphenyl type epoxy resins; xylylene type epoxy resins; biphenylaralkyl type epoxy resins; naphthalene type epoxy resins; diglycidyl ether compounds of polycyclic aromatic compounds such as anthracene; alicyclic epoxy compounds such as 1,2-cyclohexanedicarboxylic acid diglycidyl ester and 3,4-epoxycyclohexylmethyl(3,4-epoxy)cyclohexane carboxylate; aliphatic epoxy resins such as 1,2-propylene glycol diglycidyl ether, neopentyl glycol diglycidyl ether, and 1,4-butanediol diglycidyl ether; and aminophenol-type epoxy resins. Of these, bisphenol type epoxy resins, aliphatic type epoxy resins, and aminophenol-type epoxy resins are preferably used. One of them may be used alone, or a combination of two or more may be used.

The amount of the component (C) added is preferably 1 to 30 parts by mass and more preferably 5 to 20 parts by mass based on 100 parts by mass of the component (A). When the amount used is within the above range, the adhesiveness of the solder resist to be formed is good, and a low relative dielectric constant and a low dielectric loss tangent are achieved.

### (D) Curing accelerator

The component (D) used in the invention is a curing accelerator. Any curing accelerator may be used so long as it can facilitate the curing of the bismaleimide compound (A), the citraconimide compound (B), and the epoxy resin (C), and a well-known curing accelerator such as a imidazole-based curing accelerator, an organic phosphorus-based curing accelerator, or a tertiary amine-based curing accelerator can be used.

Examples of the imidazole-based curing accelerator include imidazole compounds such as 2-methylimidazole, 2-phenylimidazole, 2-ethyl-4-methylimidazole, and 2-phenyl-4-methylimidazole. Examples of the organic phosphorus-based curing accelerator include: phosphines such as triphenylphosphine, tributylphosphine, tri(p-methylphenyl)phosphine, and tri(nonylphenyl)phosphine; phosphine-borane complexes such as triphenylphosphine-triphenylborane; phosphonium borates such as tetraphenylphosphonium tetraphenylborate, tetraphenylphosphonium tetra-p-tolylborate, p-tolyltriphenylphosphonium tetra-p-tolylborate, and tri-tert-butylphosphonium tetraphenylborate; and bis(tetrabutylphosphonium)dihydrogen pyromellitate. Examples of the tertiary amine-based curing accelerator include: tertiary amine compounds such as triethylamine, benzyldimethylamine, α-methylbenzyldimethylamine, and 1,8-diazabicyclo[5.4.0]
undecene-7; and salts of tertiary amine compounds such as 1,8-diazabicyclo[5.4.0]
undecene-7. Of these, imidazole-based curing accelerators are preferred. One of them may be used alone, or a combination of two or more may be used.

The amount of the component (D) added is preferably 0.1 to 10 parts by mass and more preferably 0.5 to 5 parts by mass based on 100 parts by mass of the total amount of the component (A), the component (B), and the component (C) in the curable resin composition of the invention. When the amount of the component (D) is within the above range, the resin composition can be cured sufficiently without any adverse effects on the physical properties of the resin composition.

### (E) Inorganic filler

The component (E) used in the invention is an inorganic filler. The inorganic filler is added for the purpose of improving the resin strength and solder heat resistance of the curable resin composition of the invention and achieving small thermal expansion. Examples of the inorganic filler include silica (such as fused silica, crystalline silica, and cristobalite), barium sulfate, alumina, talc, mica, silicon nitride, aluminum nitride, boron nitride, titanium oxide, glass fibers, calcium carbonate, magnesium carbonate, and magnesium oxide. One of them may be used alone, or a combination of two or more may be used.

No particular limitation is imposed on the shape of the inorganic filler, and the inorganic filler may have, for example, a spherical shape, a scaly shape, a flaky shape, a needle shape, a rod shape, an elliptical shape, etc. In particular, the inorganic filler has preferably a spherical shape, a scaly shape, a flaky shape, an elliptical shape, or a rod shape and more preferably a spherical shape, a scaly shape, or a flaky shape.

No particular limitation is imposed on the primary particle diameter of the inorganic filler. However, its median diameter measured using a laser diffraction particle size distribution measurement apparatus is preferably 0.05 to 500 µm, more preferably, 0.1 to 300 µm, and still more preferably 1 to 100 µm. When the median diameter is within the above range, the inorganic filler can be easily and uniformly distributed in the curable resin composition of the invention and prevented from undergoing sedimentation, separation, and segregation over time.

No particular limitation is imposed on the amount of the component (E) added. However, the amount of the component (E) is preferably 10 to 500 parts by mass, more preferably 30 to 400 parts by mass, and still more preferably 50 to 300 parts by mass based on 100 parts by mass of the total of the component (A), the component (B), and the component (C) in the curable resin composition of the invention. When the amount of the component (E) is within the above range, the inorganic filler can exert its function sufficiently while the strength of the curable resin composition of the invention is maintained.

The inorganic filler used may have been subjected to surface treatment in advance using a coupling agent such as a silane coupling agent or a titanate coupling agent in order to increase the bonding strength between the resin and the inorganic filler. Examples of such a coupling agent include silane coupling agents including: epoxysilanes such as γ-glycidoxypropyltrimethoxysilane, γ-glycidoxypropylmethyldiethoxysilane, and β-(3,4-epoxycyclohexyl)ethyltrimethoxysilane; aminosilanes such as N-β(aminoethyl)-γ-aminopropyltrimethoxysilane, a reaction product of imidazole and γ-glycidoxypropyltrimethoxysilane, γ-aminopropyltriethoxysilane, and N-phenyl-γ-aminopropyltrimethoxysilane; and mercaptosilanes such as γ-mercaptosilane and γ-episulfidoxypropyltrimethoxysilane. No particular limitation is imposed on the amount of the coupling agent used for the surface treatment and the surface treatment method.

### (F) Organic solvent

The component (F) used in the invention is an organic solvent. The organic solvent is added for the purpose of adjusting the viscosity and improving printing workability, and any organic solvent capable of partially or fully dissolving the resin used as the component (A) can be used.

In the present invention, the component (F) is an optional component and is preferably added from the foregoing point of view.

Examples of the component (F) include ethyl acetate, butyl acetate, cellosolve acetate, butyl cellosolve acetate, carbitol acetate, butyl carbitol acetate, ethyldiglycolacetate, diethylene glycol monomethyl ether acetate, diethylene glycol monoethyl ether acetate, methyl ethyl ketone, cyclohexanone, toluene, xylene, anisole, methanol, isopropanol, cyclohexanol, cyclohexane, cyclopentanone, cyclohexanone, methylcyclohexane, γ-butyrolactone, tetrahydrofuran, 1,4-dioxane, N-methylpyrrolidone, N-vinylpyrrolidone, N,N-dimethylacetamide, N,N-dimethylformamide, dimethyl sulfoxide, 1,3-dimethyl-2-imidazolidinone, petroleum ether, petroleum naphtha, cellosolve, butyl cellosolve, carbitol, and butyl carbitol. One of them may be used alone, or a combination of two or more may be used.

When the curable resin composition of the invention is used for screen printing, it is preferable that the organic solvent used has a boiling point at atmospheric pressure (1013 hPa) of 200°C or higher from the viewpoint of continuous printability. Examples of the organic solvent having a boiling point of 200°C or higher include diethylene glycol monoethyl ether acetate and diethylene glycol monobutyl ether acetate.

No particular limitation is imposed on the amount of the organic solvent (F), but the amount is preferably 10 to 300 parts by mass, more preferably 30 to 200 parts by mass, and still more preferably 50 to 100 parts by mass based on 100 parts by mass of the total of the component (A), the component (B), and the component (C) in the curable resin composition of the invention. When the amount of the organic solvent (F) is within the above range, blurring of the curable resin composition of the invention when the curable resin composition is used to form a film by printing can be prevented, and the drying rate can be adjusted appropriately to prevent the printing plate from drying too fast, so that the curable resin composition is suitable in terms of printing workability (particularly continuous printability).

### Additional additives

In addition to the components (A) to (F), additional additives may be optionally added to the curable resin composition of the invention so long as the object and effects of the invention are not impaired. Examples of the additives include a coloring agent, an antifoaming agent, a flame retardant, an ion trapping agent, an antioxidant, an adhesion promoter, and a stress-reducing agent. One of these additives may be used alone, or a combination of two or more may be used. Each additive may be of only one type or composed of two or more types.

The coloring agent is added in order to enhance the visibility of a product produced using the curable resin composition of the invention for solder resist use during inspection. No particular limitation is imposed on the coloring agent, and any well-known coloring agent can be used. Examples of the coloring agent include titanium oxide, zinc white, carbon black, molybdenum red, prussian blue, cobalt blue, azo-based pigments, phthalocyanine-based pigments, quinacridone-based pigments, isoindoline-based pigments, indanthrene-based pigments, perylene-based pigments, dioxazine-based pigments, and diketopyrrolopyrrole-based pigments.

From the viewpoint that coloration can be achieved using a relatively small amount of the coloring agent and from the viewpoint of visibility during inspection, carbon black, phthalocyanine-based pigments, and azo-based pigments are preferred.

The antifoaming agent is used to prevent the formation of foam during printing or coating with the curable resin composition of the invention for solder resist use or during curing of the curable resin composition. Examples of the antifoaming agent include silicone-based antifoaming agents, acrylic-based antifoaming agents, fluorine-based antifoaming agents, and polymer-based antifoaming agent.

The flame retardant is added to the curable resin composition of the invention for solder resist use for the purpose of imparting flame retardancy. No particular limitation is imposed on the flame retardant, and any well-known flame retardant can be used. Examples of the flame retardant include phosphazene compounds, silicone compounds, zinc molybdate-coated talc, zinc molybdate-coated zinc oxide, aluminum hydroxide, magnesium hydroxide, and molybdenum oxide.

The ion trapping agent is added for the purpose of capturing ionic impurities in the resin composition to prevent thermal deterioration and moisture-induced deterioration. No particular limitation is imposed on the ion trapping agent, and any well-known ion trapping agent can be used. Examples of the ion trapping agent include hydrotalcites, bismuth hydroxide compounds, and rare earth oxides.

No particular limitation is imposed on the antioxidant. Examples of the antioxidant include: phenol-based antioxidants such as n-octadecyl-3-(3,5-di-t-butyl-4-hydroxyphenyl)propionate, n-octadecyl-3-(3,5-di-t-butyl-4-hydroxyphenyl)acetate, neododecyl-3-(3,5-di-t-butyl-4-hydroxyphenyl)propionate, dodecyl-β-(3,5-di-t-butyl-4-hydroxyphenyl)propionate, ethyl-α-(4-hydroxy-3,5-di-t-butylphenyl)isobutyrate, octadecyl-α-(4-hydroxy-3,5-di-t-butylphenyl)isobutyrate, octadecyl-α-(4-hydroxy-3,5-di-t-butyl-4-hydroxyphenyl)propionate, 2-(n-octylthio)ethyl-3,5-di-t-butyl-4-hydroxyphenylacetate, 2-(n-octadecylthio)ethyl-3,5-di-t-butyl-4-hydroxyphenylacetate, 2-(n-octadecylthio)ethyl-3-(3,5-dit-butyl-4-hydroxyphenyl)propionate, 2-(2-stearoyloxyethylthio)ethyl-7-(3-methyl-5-t-butyl-4-hydroxyphenyl)heptanoate, 2-hydroxyethyl-7-(3-methyl-5-t-butyl-4-hydroxyphenyl)propionate, and pentaerythritol tetrakis[3-(3,5-di-t-butyl-4-hydroxyphenyl)propionate]; sulfur-based antioxidants such as dilauryl-3,3'-thiodipropionate, dimyristyl-3,3'-thiodipropionate, distearyl-3,3'-thiodipropionate, ditridecyl-3,3'-thiodipropionate, and pentaerythrityl tetrakis(3-laurylthiopropionate); and phosphorus-based antioxidants such as tridecyl phosphite, triphenyl phosphite, tris(2,4-di-t-butylphenyl)phosphite, 2-ethylhexyl diphenyl phosphite, diphenyl tridecyl phosphite, 2,2-methylenebis(4,6-di-t-butylphenyl)octyl phosphite, distearyl pentaerythritol diphosphite, bis(2,6-di-t-butyl-4-methylphenyl)pentaerythritol diphosphite, and 2-[[2,4,8,10-tetrakis(1,1-dimethylethyl)dibenzo[d,f][1,3,2]
dioxaphosphepin-6-yl]oxy]-N,N-bis[2-[[2,4,8,10-tetrakis(1,1-dimethylethyl)dibenzo[d,f][1,3,2]
dioxaphosphepin-6-yl]oxy]-ethyl]ethanamine.

No particular limitation is imposed on the adhesion promoter, and any well-known adhesion promoter can be used so long as it can impart adhesiveness or tackiness (pressure-sensitive adhesiveness). Examples of the adhesion promoter include urethane resins, phenolic resins, terpene resins, and silane coupling agents. In particular, silane coupling agents are preferred in order to impart adhesiveness.

No particular limitation is imposed on the silane coupling agent. Examples of the silane coupling agent include n-propyltrimethoxysilane, n-propyltriethoxysilane, n-octyltrimethoxysilane, n-octyltriethoxysilane, phenyltrimethoxysilane, phenyltriethoxysilane, methyltrimethoxysilane, methyltriethoxysilane, 2-[methoxy(polyethyleneoxy)propyl]-trimethoxysilane, methoxytri(ethyleneoxy)propyltrimethoxysilane, 3-glycidyloxypropyltrimethoxysilane, 3-aminopropyltrimethoxysilane, 3-mercaptopropyltrimethoxysilane, 3-(methacryloyloxy)propyltrimethoxysilane, 3-isocyanatopropyltriethoxysilane, and 3-isocyanatopropyltrimethoxysilane.

The amount of the additional additives varies depending on the intended purpose of the composition but is generally 5% by mass or less based on the total amount of the curable resin composition of the invention except for the inorganic filler (E) and the organic solvent (F).

### Method for producing composition

The curable resin composition of the invention can be produced by the following method.

For example, the components (A) to (E) or (A) to (F) are mixed simultaneously or separately while heat treatment is optionally performed, and the mixture is stirred until dissolution and/or dispersion is complete to thereby obtain a mixture of the components (A) to (E) or (A) to (F). Preferably, the curing accelerator (D) is added to a mixture of the components (A) to (C) and (E) or (A) to (C), (E), and (F) excluding the curing accelerator (D), and the resulting mixture is stirred until dissolution and/or dispersion is complete to thereby obtain a mixture of the components (A) to (E) or (A) to (F). In some applications, at least one addition additive selected from the coloring agent, the antifoaming agent, the flame retardant, the ion trapping agent, the antioxidant, the adhesion promoter, and a stress-reducing agent may be added to and mixed with the mixture of the components (A) to (E) or (A) to (F). Each of the components (A) to (F) and the additional additives may be of only one type or composed of two or more types.

No particular limitation is imposed on the apparatus used for mixing, stirring, and dispersion in the method for producing the curable resin composition of the invention. Specifically, for example, a grinding machine provided with a stirrer and a heater, a two-roll mill, a three-roll mill, a ball mill, a planetary mixer, or a Masscolloider may be used, and an appropriate combination of any of these apparatuses may also be used.

### Method for forming coating

A method for forming a coating in the invention is a coating forming method including the step of applying the curable resin composition of the invention by printing such as screen printing to a base to thereby form a resist film having a desired pattern.

The screen printing is a method generally including forming a pattern on a fabric (screen) formed of nylon, Tetron (registered trademark), stainless steel, etc. using a resist and squeezing the resin composition through the openings of the screen onto the base for printing.

A method for applying the curable resin composition of the invention to the surface of a base by screen printing will be described. First, the surface of the base is covered with a screen mask having openings forming a desired pattern, and the curable resin composition is charged into a squeegee section. Then the squeegee is moved on the screen mask while pressure is applied to the curable resin composition, and the openings of the masking member are thereby filled with the curable resin composition (a filling step). Next, the screen mask is removed. The pattern of the curable resin composition can thereby be formed on the surface of the base.

No particular limitation is imposed on the base. However, the base is preferably a resin surface substrate formed of a phenol resin, an epoxy resin, a polyamide resin, a polyimide resin, a reinforced resin prepared by reinforcing any of these resins with glass fibers, etc. or a layered base including a glass substrate and a film of an electroconductive metal such as copper, gold, silver, aluminum, or chromium formed by lamination, vacuum deposition, etc. The substrate and the metal film in the base may each be composed of one layer or a plurality of layers. The base may have through-holes or non-through holes. No particular limitation is imposed on the thickness and shape of the base.

The thickness of the dry coating formed using the curable resin composition of the invention is preferably 5 to 100 µm and more preferably 10 to 30 µm in order to prevent peeling due to external shock during a working process, to ensure solder heat resistance, to prevent solvent outgassing from the coating, and to prevent entrainment of air bubbles during application.

In the screen printing method, it is preferable to use a fine mesh screen, particularly preferably a screen with a size of about 100 to 400 mesh in order to accommodate high-definition circuit patterns. The opening area of the screen in this case is preferably about 20 to 50%.

Examples of the type of screen printing plate include polyester screens, combination screens, metal screens, and nylon screens. Moreover, a high-tension stainless steel screen can be used when a highly viscous paste material is used for printing.

The squeegee used for screen printing may have a round, rectangular, or square shape. A ground squeegee may also be used in order to decrease the attack angle (the angle between the plate and the squeegee during printing). The other printing conditions may be appropriately determined according to conventional conditions.

The curable resin composition of the invention applied by printing can be dried by heating. The drying conditions may be appropriately determined according to the type of organic solvent used. Generally, the drying temperature is, for example, in the range of 80 to 200°C and preferably 120 to 190°C, and the drying time is 1 to 100 minutes and preferably 20 to 80 minutes. No particular limitation is imposed on the heating device, and, for example, an air heating furnace or an electric furnace can be used.

### Applications

The resolution of the pattern formed by screen printing using the curable resin composition of the invention is high. The coating thickness of the pattern is uniform, and mesh clogging, blurring, and deterioration of bubble releasability do not occur. Moreover, the resin composition of the present invention exhibits good continuous formability, and its cured product has high heat resistance and good dielectric characteristics. Therefore, the curable resin composition of the invention is particularly suitable for solder resist applications. The curable resin composition of the invention can be used as a screen printing resin composition suitable for wide variety of applications such as the formation of interlayer insulating materials, passivation films on semiconductor device surfaces at the wafer level, protective films, diodes, pigment resists for color filters, junction protection films for junctions in transistors etc., protection films for liquid crystal color filters, protection films for glass fibers, surface protection films for solar cells, and electroconductive films containing electroconductive fillers.

### WORKING EXAMPLES

The present invention will next be described more specifically by way of Synthesis Examples, Working Examples, and Comparative Examples. However, the present invention is not limited to the following Examples. In the Synthesis Examples, Working Examples, and Comparative Examples, "room temperature" means 25°C. In Tables 1A and 1B and Table 2, each amount is expressed in parts by mass.

Components used in the Working Examples and Comparative Examples are shown below. In the following description, the number average molecular weight (Mn) is measured by gel permeation chromatography (GPC) with respect to polystyrene under the following measurement conditions.

### [GPC measurement conditions]

Eluent: Tetrahydrofuran
Flow rate: 0.35 mL/min
Columns:
   TSKgel guardcolumn SuperHZ-L (4.6 mm I.D. × 2 cm × 1)
   TSKgel SuperH-RC (6.0 mm I.D. × 15 cm × 2)
   TSKgel SuperHZ 4000 (4.6 mm I.D. × 15 cm × 1)
   TSKgel SuperHZ 3000 (4.6 mm I.D. × 15 cm × 1)
   TSKgel SuperHZ 2000 (4.6 mm I.D. × 15 cm × 2)
   (all manufactured by TOSOH Corporation)
Column temperature: 40°C
Sample injection volume: 10 µL (sample concentration: 0.2% by mass - tetrahydrofuran solution)
   Detector: Differential refractometer (RI)
Component A: Bismaleimide compound

### Synthesis Example 1 Synthesis of bismaleimide compound A-1

A 1 L glass-made four-neck flask equipped with a stirrer, a Dean-Stark tube, a cooling condenser, and a thermometer was charged with 28.38 g (0.167 moles) of isophoronediamine, 104.10 g (0.200 moles) of 4,4'-(4,4'-isopropylidenediphenoxy)diphthalic anhydride, 250 g of toluene, 250 g of N-methyl-2-pyrrolidone, and 9.61 g (0.100 moles) of methanesulfonic acid, and the mixture was stirred at 80°C for 3 hours to synthesize an amic acid. Then the resulting mixture was heated to 120°C and stirred for 8 hours while water generated as a byproduct was removed by evaporation to synthesize a block copolymer. Then the flask containing the block copolymer solution cooled to 80°C was charged with 44.53 g (0.083 moles) of Priamine-1075 (dimer diamine represented by average compositional formula: H₂N-C₃₆H₇₀-NH₂, manufactured by CRODA), and the mixture was stirred at 80°C for 2 hours to synthesize an amic acid. Then the resulting mixture was heated to 120°C and stirred for 8 hours while water generated as a byproduct was removed by evaporation to synthesize a telechelic diamine. The flask containing the obtained telechelic diamine solution was cooled to room temperature. Then 10.79 g (0.110 moles) of maleic anhydride was added, and the resulting mixture was stirred at room temperature for 2 hours to synthesize a maleamic acid. Then the resulting mixture was heated to 120°C and stirred for 8 hours while water generated as a byproduct was removed by evaporation to thereby synthesize a bismaleimide. The obtained solution was washed 10 times with an aqueous solution mixture of water and isopropyl alcohol to remove impurities such as catalysts. Then water in the system, along with toluene, was subjected to azeotropic dehydration by distillation under reduced pressure to thereby obtain a blown varnish solution with a solid content of 50% by mass. In the varnish solution, a bismaleimide compound having a structure represented by the following formula (A-1) was in a dissolved state in toluene. The number average molecular weight of the obtained bismaleimide compound was 5,200. 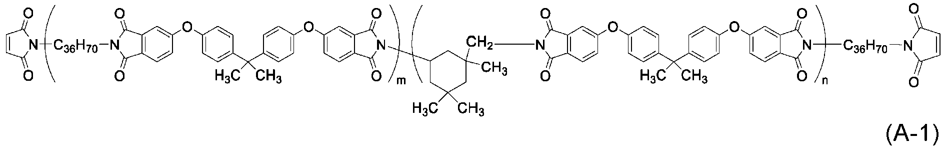
m ≈ 3, n ≈ 6 (both average values)
-C₃₆H₇₀- is a hydrocarbon group derived from a dimer acid skeleton originating from the dimer diamine (Priamine-1075).

### Synthesis Example 2 Synthesis of bismaleimide compound A-2

A 1 L glass-made four-neck flask equipped with a stirrer, a Dean-Stark tube, a cooling condenser, and a thermometer was charged with 52.27 g (0.150 moles) of 9,9-bis(4-aminophenyl)fluorene, 104.10 g (0.200 moles) of 4,4'-(4,4'-isopropylidenediphenoxy)diphthalic anhydride, 250 g of toluene, 250 g of N-methyl-2-pyrrolidone, and 9.61 g (0.100 moles) of methanesulfonic acid, and the mixture was stirred at 80°C for 3 hours to synthesize an amic acid. Then the resulting mixture was heated to 120°C and stirred for 8 hours while water generated as a byproduct was removed by evaporation to synthesize a block copolymer. Then the flask containing the block copolymer solution cooled to 80°C was charged with 53.44 g (0.100 moles) of Priamine-1075 (dimer diamine represented by average compositional formula: H₂N-C₃₆H₇₀-NH₂, manufactured by CRODA), and the mixture was stirred at 80°C for 2 hours to synthesize an amic acid. Then the resulting mixture was heated to 120°C and stirred for 8 hours while water generated as a byproduct was removed by evaporation to synthesize a telechelic diamine. The flask containing the obtained telechelic diamine solution was cooled to room temperature. Then 10.79 g (0.110 moles) of maleic anhydride was added, and the resulting mixture was stirred at room temperature for 2 hours to synthesize a maleamic acid. Then the resulting mixture was heated to 120°C and stirred for 8 hours while water generated as a byproduct was removed by evaporation to synthesize a bismaleimide. The obtained solution was washed 10 times with an aqueous solution mixture of water and isopropyl alcohol to remove impurities such as catalysts. Then water in the system, along with toluene, was subjected to azeotropic dehydration by distillation under reduced pressure to thereby obtain a blown varnish solution with a solid content of 50% by mass. In the varnish solution, a bismaleimide compound having a structure represented by the following formula (A-2) was in a dissolved state in toluene. The number average molecular weight of the obtained bismaleimide compound was 6,200. 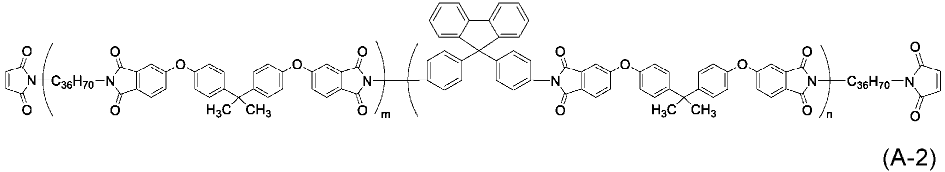
m ≈ 3, n ≈ 4 (both average values)
-C₃₆H₇₀- is a hydrocarbon group derived from a dimer acid skeleton originating from the dimer diamine (Priamine-1075).

### Synthesis Example 3 Synthesis of bismaleimide compound A-3

A 1 L glass-made four-neck flask equipped with a stirrer, a Dean-Stark tube, a cooling condenser, and a thermometer was charged with 44.40 g (0.167 moles) of 1-(4-aminophenyl)-2,3-dihydro-1,3,3-trimethyl-1H-indene-5-amine, 104.10 g (0.20 moles) of 4,4'-(4,4'-isopropylidenediphenoxy)diphthalic anhydride, 250 g of toluene, 250 g of N-methyl-2-pyrrolidone, and 9.61 g (0.10 moles) of methanesulfonic acid, and the mixture was stirred at 80°C for 3 hours to synthesize an amic acid. Then the resulting mixture was heated to 120°C and stirred for 8 hours while water generated as a byproduct was removed by evaporation to synthesize a block copolymer. Then the flask containing the block copolymer solution cooled to 80°C was charged with 44.53 g (0.083 moles) of Priamine-1075 (dimer diamine represented by average compositional formula: H₂N-C₃₆H₇₀-NH₂, manufactured by CRODA), and the mixture was stirred at 80°C for 2 hours to synthesize an amic acid. Then the resulting mixture was heated to 120°C and stirred for 8 hours while water generated as a byproduct was removed by evaporation to synthesize a telechelic diamine. The flask containing the obtained telechelic diamine solution was cooled to room temperature. Then 10.79 g (0.110 moles) of maleic anhydride was added, and the resulting mixture was stirred at room temperature for 2 hours to synthesize a maleamic acid. Then the resulting mixture was heated to 120°C and stirred for 8 hours while water generated as a byproduct was removed by evaporation to synthesize a bismaleimide. The obtained solution was washed 10 times with an aqueous solution mixture of water and isopropyl alcohol to remove impurities such as catalysts. Then water in the system, along with toluene, was subjected to azeotropic dehydration by distillation under reduced pressure to thereby obtain a blown varnish solution with a solid content of 50% by mass. In the varnish solution, a bismaleimide compound having a structure represented by the following formula (A-3) was in a dissolved state in toluene. The number average molecular weight of the obtained bismaleimide compound was 7,700. 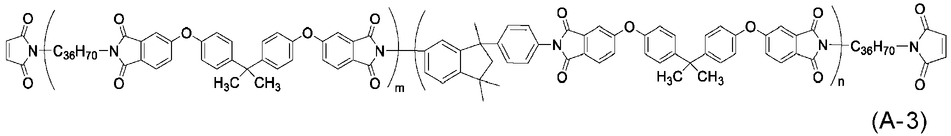
m ≈ 3, n ≈ 6 (both average values)
-C₃₆H₇₀- is a hydrocarbon group derived from a dimer acid skeleton originating from the dimer diamine (Priamine-1075).

### Maleimide compounds for Comparative Examples

(A'-1): Bismaleimide compound represented by the following formula (A'-1) (SLK-3000 manufactured by Shin-Etsu Chemical Co., Ltd., number average molecular weight: 7,500) 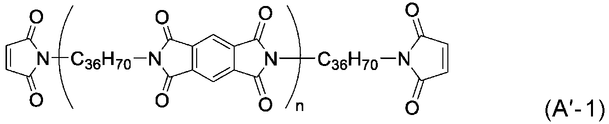
n ≈ 10 (average value)
-C₃₆H₇₀- is a hydrocarbon group derived from a dimer acid skeleton originating from the dimer diamine (Priamine-1075).

(A'-2): Bismaleimide compound represented by the following formula (A'-2) (SLK-1500 manufactured by Shin-Etsu Chemical Co., Ltd., number average molecular weight: 2,400) 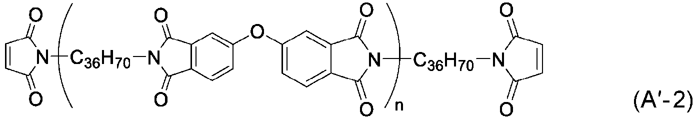
n ≈ 2 (average value)
-C₃₆H₇₀- is a hydrocarbon group derived from a dimer acid skeleton originating from the dimer diamine (Priamine-1075).

(A'-3): Bismaleimide compound represented by the following formula (A'-3) (BMI-TMH manufactured by Daiwakasei Industry Co., Ltd., number average molecular weight: 500)

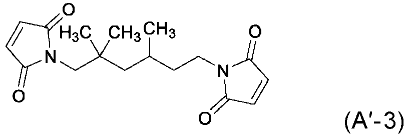

(A'-4): Bismaleimide compound represented by the following formula (A'-4) (BMI-2300 manufactured by Daiwakasei Industry Co., Ltd., number average molecular weight: 400) 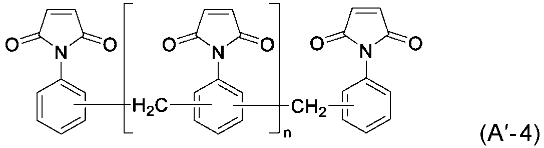 n ≈ 2 (average value)

### (B) Citraconimide compound

### [Synthesis Example 4]

### Synthesis of citraconimide compound B-1

A 1 L glass-made four-neck flask equipped with a stirrer, a Dean-Stark tube, a cooling condenser, and a thermometer was charged with 71.2 g (0.45 moles) of 2,2,4-trimethylhexanediamine, 111.0 g (0.99 moles) of citraconic anhydride, and 150 g of toluene to prepare a reaction mixture, and the reaction mixture was stirred at 80°C for 3 hours to synthesize an amic acid. Then 40 g of methanesulfonic acid was added to the reaction mixture, and the resulting mixture was heated to 110°C and stirred for 16 hours while water generated as a byproduct was removed by evaporation. Then the resulting reaction mixture was washed 5 times with 200 g of ion exchanged water. Then vacuum stripping was performed at 60°C, and a target compound represented by (B-1) was obtained as a brown liquid at room temperature. The number average molecular weight of the obtained citraconimide compound was 590.

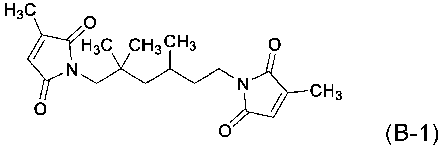

### Synthesis Example 5 Synthesis of citraconimide compound B-2

A 1 L glass-made four-neck flask equipped with a stirrer, a Dean-Stark tube, a cooling condenser, and a thermometer was charged with 155.0 g (0.45 moles) of bisaniline M, 111.0 g (0.99 moles) of citraconic anhydride, and 150 g of toluene to prepare a reaction mixture, and the reaction mixture was stirred at 80°C for 3 hours to synthesize an amic acid. Then 40 g of methanesulfonic acid was added to the reaction mixture, and the resulting reaction mixture was heated to 110°C and stirred for 16 hours while water generated as a byproduct was removed by evaporation. The resulting reaction mixture was washed 5 times with 200 g of ion exchanged water. Then vacuum stripping was performed at 60°C, and a target compound represented by (B-2) was obtained as a yellow liquid at room temperature. The number average molecular weight of the obtained citraconimide compound was 530.

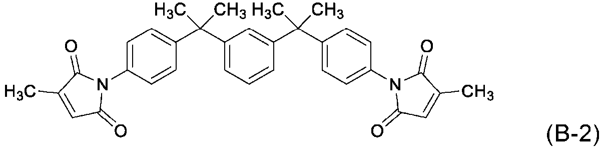

### (C) Epoxy resin

(C-1) Mixture of bisphenol A type epoxy resin and bisphenol F type epoxy resin (ZX-1059 manufactured by NIPPON STEEL Chemical & Material Co., Ltd., liquid at 25°C)
(C-2) Aminophenol type trifunctional epoxy resin (jER 630 manufactured by Mitsubishi Chemical Corporation, liquid at 25°C)
(C-3) Neopentyl glycol diglycidyl ether (ED-523L manufactured by ADEKA, liquid at 25°C)

### (D) Curing accelerator

(D-1) 2-Ethyl-4-methylimidazole (2E4MZ manufactured by SHIKOKU CHEMICALS CORPORATION)

### (E) Inorganic filler

(E-1) Fused spherical silica with average particle diameter of 0.6 µm (manufactured by TATSUMORI LTD.)

(F) Organic solvent

(F-1) Diethylene glycol monoethyl ether acetate (boiling point: 218°C)

### Additional components

Coloring agent 1: Phthalocyanine blue
Coloring agent 2: Pigment Yellow 147

### Working Examples 1 to 14 and Comparative Examples 1 to 8

Components were prepared in one of the ratios (parts by mass) shown in Tables 1A and 1B and Table 2, mixed until uniform, and kneaded using a three-roll mill to thereby obtain a resin composition. The printability of each of the obtained resin compositions was evaluated by a method described below. The obtained resin compositions were cured at a temperature of 180°C for 1 hour to thereby obtain cured products in Working Examples 1 to 14 and Comparative Examples 1 to 8. Properties of the obtained cured products were measured by methods described below. The results are shown in Tables 1A and 1B and Table 2.

### Evaluation of printability

One of the resin compositions in the Working Examples and Comparative Examples was applied by printing to a substrate using a screen printing apparatus (product name: MODEL M C212 manufactured by C. W. PRICE CO. INC.) and a screen mask (325 mesh, emulsion thickness: 15 µm, mesh thickness: 35 µm). In one forming step, the mask was placed, filled with the composition using a squeegee, and then removed. The forming step was continuously performed 10 times, and the shape of the pattern was checked to evaluate continuity. Each substrate after the printing was cured in an oven at 100°C for 20 minute and then at 180°C for 1 hour, and effervescence in the obtained pattern and blurring of the edges of the pattern were observed. The results are shown in Tables 1A and 1B and Table 2.

### Glass transition temperature

A dynamic viscoelasticity meter (device name: DMA Q800 manufactured by TA Instruments) was used to measure the storage elastic modulus (MPa) of each of the cured products in the range of 0°C to 300°C. The values of Tan δ derived from the values of the obtained storage elastic modulus and loss elastic modulus were plotted in a graph, and the temperature at the peak top in the graph was used as the glass transition temperature (Tg). A sample of 20 mm × 5 mm × 50 µm thick was used to perform the measurement under the conditions of a heating rate of 5°C/min, a multi-frequency mode, a tensile mode, and an amplitude of 15 µm. The results are shown in Tables 1A and 1B and Table 2.

### Coefficient of thermal expansion

A thermomechanical analyzer (device name: TMA Q400 manufactured by TA Instruments) was used to measure the coefficient of thermal expansion (CTE) of each of the cured products in the range of 50°C to 300°C to compute the coefficient of thermal expansion in the range of 0°C to 40°C. A sample of 30 mm × 3 mm × 80 µm thick was used to perform the measurement under the conditions of a heating rate of 5°C/min and a test load of 0.075 N. The results are shown in Tables 1A and 1B and Table 2.

### Relative dielectric constant and dielectric loss tangent

A network analyzer (E5063-2D5 manufactured by Keysight Technologies) was connected to a strip line (manufactured by KEYCOM Corporation), and the relative dielectric constant and dielectric loss tangent of each of the cured products at a frequency of 10 GHz were measured. The results are shown in Tables 1A and 1B and Table 2.

### Adhesiveness (peel strength of copper foil)

One of the prepared curable resin compositions was applied to a PET film such that the thickness was 25 µm to produce a resin film. Then the resulting film was placed on an SUS plate such that the side opposite to the PET film was in contact with the SUS plate, and a vacuum laminator V-130 (manufactured by Nikko-Materials Co., Ltd.) was used to perform lamination at 100°C, a vacuum of 0.6 hPa, and a pressure of 0.3 MPa for 60 seconds. The laminate was cooled to room temperature, and the PET film was peeled off. Then an 18 µm-thick copper foil (product name: TQ-M4-VSP manufactured by MITSUI KINZOKU COMPANY, LIMITED) was placed on the resin film, and the resulting product was again subjected to lamination at 80°C, a vacuum of 0.6 hPa, and a pressure of 0.3 MPa for 60 seconds and then heated at 180°C for 1 hour to cure the laminate. An autograph (AGS-500NS manufactured by Shimadzu Corporation) was used to determine the adhesion (peel strength) when the copper foil with a width of 10 mm was peeled from the resin film in a 90° direction at a rate of 50 mm/minute according to JIS-C-6481:1996 for a copper-clad laminate test for printed wiring boards. The results are shown in Tables 1A and 1B and Table 2.

### Solder heat resistance

One of the prepared curable resin compositions was applied by printing to a substrate, and a flux was applied to the substrate. The resulting substrate was immersed in a solder bath at 260°C for 10 seconds and then washed with water. This treatment was repeated three times, and the appearance of the coating was observed and evaluated according to the following criteria. The results are as shown in Tables 1A and 1B and Table 2.
o (good): No change in the appearance of the cured product layer was found.
× (poor): Delamination, blistering, discoloration, etc. were found in the cured film in the cured product layer.

**Table 1A**

| | | | Working Example 1 | Working Example 2 | Working Example 3 | Working Example 4 | Working Example 5 | Working Example 6 | Working Example 7 |
|---|---|---|---|---|---|---|---|---|---|
| (A) | Maleimide compound | (A-1) | 50 | 50 | 50 | 50 | 50 | 60 | 70 |
| | | (A-2) | | | | | | | |
| | | (A-3) | | | | | | | |
| | | (A'-1) | | | | | | | |
| | | (A'-2) | | | | | | | |
| | | (A'-3) | | | | | | | |
| | | (A'-4) | | | | | | | |
| (B) | Citraconimi de compound | (B-1) | 40 | | 40 | 40 | 40 | 30 | 20 |
| | | (B-2) | | 40 | | | | | |
| (C) | Epoxy resin | (C-1) | 10 | 10 | | | 2.5 | 10 | 10 |
| | | (C-2) | | | 10 | | 2.5 | | |
| | | (C-3) | | | | 10 | 5 | | |
| (D) | Curing accelerator | (D-1) | 1 | 1 | 1 | 1 | 1 | 1 | 1 |
| (E) | Inorganic filler | (E-1) | 150 | 150 | 150 | 150 | 150 | 150 | 150 |
| (F) | Organic solvent | (F-1) | 65 | 65 | 65 | 65 | 80 | 75 | 90 |
| Additional component | | Coloring agent 1 | 1 | 1 | 1 | 1 | 1 | 1 | 1 |
| | | Coloring agent 2 | 1 | 1 | 1 | 1 | 1 | 1 | 1 |
| Evalua tion results | Printability | Continuity | Good | Good | Good | Good | Good | Good | Good |
| | | Effervesce nce | Absent | Absent | Absent | Absent | Absent | Absent | Absent |
| | | Blurring | Absent | Absent | Absent | Absent | Absent | Absent | Absent |
| | Glass transition temperature [°C] | | 168 | 170 | 165 | 166 | 170 | 162 | 157 |
| | Coefficient of thermal expansion [ppm/K] | | 31 | 29 | 31 | 32 | 29 | 31 | 34 |
| | Relative dielectric constant (10 GHz) | | 3.0 | 3.0 | 3.0 | 3.0 | 3.0 | 3.0 | 3.0 |
| | Dielectric loss tangent (10 GHz) | | 0.0030 | 0.0032 | 0.0031 | 0.0029 | 0.0029 | 0.0027 | 0.0025 |
| | Peel strength of copper foil [kN/m] | | 0.8 | 0.8 | 0.7 | 0.7 | 0.8 | 0.8 | 0.8 |
| | Solder heat resistance | | ○ | ○ | ○ | ○ | ○ | ○ | ○ |

**Table 1B**

| | | | Working Example 8 | Working Example 9 | Working Example 10 | Working Example 11 | Working Example 12 | Working Example 13 | Working Example 14 |
|---|---|---|---|---|---|---|---|---|---|
| (A) | Maleimide compound | (A-1) | | | | | 30 | | 35 |
| | | (A-2) | 50 | 50 | | | 25 | 40 | |
| | | (A-3) | | | 50 | 50 | | | |
| | | (A'-1) | | | | | | | |
| | | (A'-2) | | | | | | | |
| | | (A'-3) | | | | | | | |
| | | (A'-4) | | | | | | | |
| (B) | Citraconimi de compound | (B-1) | 40 | | 40 | | 30 | | 30 |
| | | (B-2) | | 40 | | 40 | | 45 | 20 |
| (C) | Epoxy resin | (C-1) | 10 | 10 | 10 | 10 | 2.5 | 2.5 | 2.5 |
| | | (C-2) | | | | | 2.5 | 2.5 | 2.5 |
| | | (C-3) | | | | | 10 | 10 | 10 |
| (D) | Curing accelerator | (D-1) | 1 | 1 | 1 | 1 | 1 | 1 | 1 |
| (E) | Inorganic filler | (E-1) | 150 | 150 | 150 | 150 | 100 | 100 | 230 |
| (F) | Organic solvent | (F-1) | 65 | 65 | 65 | 65 | 65 | 65 | 80 |
| Additional component | | Coloring agent 1 | 1 | 1 | 1 | 1 | 1 | 1 | 1 |
| | | Coloring agent 2 | 1 | 1 | 1 | 1 | 1 | 1 | 1 |
| Evalua tion results | Printability | Continuity | Good | Good | Good | Good | Good | Good | Good |
| | | Effervesce nce | Absent | Absent | Absent | Absent | Absent | Absent | Absent |
| | | Blurring | Absent | Absent | Absent | Absent | Absent | Absent | Absent |
| | Glass transition temperature [°C] | | 185 | 190 | 178 | 181 | 180 | 192 | 160 |
| | Coefficient of thermal expansion [ppm/K] | | 27 | 27 | 28 | 29 | 34 | 35 | 19 |
| | Relative dielectric constant (10 GHz) | | 3.2 | 3.2 | 3.1 | 3.1 | 3.0 | 3.0 | 3.2 |
| | Dielectric loss tangent (10 GHz) | | 0.0027 | 0.0030 | 0.0030 | 0.0031 | 0.0028 | 0.0034 | 0.0023 |
| | Peel strength of copper foil [kN/m] | | 0.8 | 0.7 | 0.8 | 0.8 | 0.8 | 0.9 | 0.7 |
| | Solder heat resistance | | ○ | ○ | ○ | ○ | ○ | ○ | ○ |

**Table 2**

| | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|
| (A) | Maleimide compound | (A-1) | | | 50 | 50 | | 90 | 60 | 50 |
| | | (A-2) | | | | | | | | |
| | | (A-3) | | | | | | | | |
| | | (A'-1 ) | 50 | | | | | | | |
| | | (A'-2) | | | 40 | | | | | |
| | | (A'-3) | | | | 40 | | | | |
| | | (A'-4) | | 50 | | | | | | |
| (B) | Citraconimide compound | (B-1) | 40 | 40 | | | 90 | | 40 | 40 |
| | | (B-2) | | | | | | | | |
| (C) | Epoxy resin | (C-1) | 10 | 10 | 10 | 10 | 10 | 10 | | 10 |
| | | (C-2) | | | | | | | | |
| | | (C-3) | | | | | | | | |
| (D) | Curing accelerator | (D-1) | 1 | 1 | 1 | 1 | 1 | 1 | 1 | 1 |
| (E) | Inorganic filler | (E-1) | 150 | 150 | 150 | 150 | 150 | 150 | 150 | |
| (F) | Organic solvent | (F-1) | 40 | 40 | 65 | 65 | 10 | 80 | 65 | 65 |
| Additional component | | Coloring agent 1 | 1 | 1 | 1 | 1 | 1 | 1 | 1 | 1 |
| | | Coloring agent 2 | 1 | 1 | 1 | 1 | 1 | 1 | 1 | 1 |
| Evaluation results | Printability | Continuity | Good | Poor | Good | Poor | Good | Poor | Good | Good |
| | | Effervescence | Absent | | Absent | Absent | Present | Present | Absent | Present |
| | | Blurring | Absent | Present | Present | Present | Present | Present | Absent | Present |
| | Glass transition temperature [°C] | | 86 | 250< | 112 | 165 | Incomplete curing | 155 | Incomplete curing | 168 |
| | Coefficient of thermal expansion [ppm/K] | | 50 | 25 | 55 | 32 | | 38 | | 65 |
| | Relative dielectric constant (10 GHz) | | 2.9 | 3.5 | 2.9 | 3 | | 2.9 | | 2.7 |
| | Dielectric loss tangent (10 GHz) | | 0.0029 | 0.0185 | 0.0029 | 0.0041 | | 0.0024 | | 0.0052 |
| | Peel strength of copper foil [kN/m] | | 1.0 | 0.3 | 0.8 | 0.8 | | 0.8 | | 08 |
| | Solder heat resistance | | × | × | ○ | ○ | | ○ | | × |

As can be seen from the above results, the printability of each curable resin composition in the invention for solder resist use is good. The cured product of each composition has a high glass transition temperature, a low coefficient of thermal expansion, high solder heat resistance, good adhesiveness, a low relative dielectric constant, and a low dielectric loss tangent. In particular, each curable resin composition in the invention has a higher glass transition temperature, a lower coefficient of thermal expansion, and higher solder heat resistance than those of the resin composition in Comparative Example 1 that uses a bismaleimide compound not including the hydrocarbon group having a divalent alicyclic structure or the hydrocarbon group having an aromatic ring in the component (A) in the invention.

The printability of the curable resin composition of the invention for solder resist use is good, and the cured product of the composition has a high glass transition temperature, a low coefficient of thermal expansion, high solder heat resistance, good adhesiveness, a low relative dielectric constant, and a low dielectric loss tangent. Therefore, the curable resin composition for solder resist use can provide a highly reliable cured product. Specifically, the curable resin composition of the invention for solder resist use can be preferably used as the technique for forming an insulating coating on a printed wiring board etc. used at high frequencies.

## Claims

1. A curable resin composition for solder resist use, comprising:
(A) a bismaleimide compound represented by formula (1) defined as 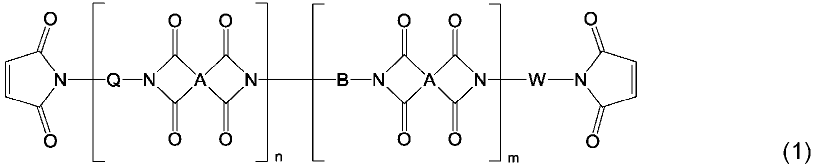 wherein, in the formula (1), each A independently represents a tetravalent organic group having a cyclic structure, each B independently represents a divalent hydrocarbon group derived from a dimer acid skeleton, each Q independently represents a divalent hydrocarbon group having an alicyclic structure or a divalent hydrocarbon group having an aromatic ring, W is B or Q, n is a number of 1 to 100, m is a number of 1 to 100, and repeating units in square brackets with subscripts n and m are arranged in any order;
(B) a citraconimide compound;
(C) an epoxy resin;
(D) a curing accelerator; and
(E) an inorganic filler.

2. The curable resin composition for solder resist use according to claim 1, further comprising (F) an organic solvent.

3. The curable resin composition for solder resist use according to claim 2, wherein the organic solvent (F) has a boiling point of 200°C or higher.

4. The curable resin composition for solder resist use according to claim 1, wherein Q in the formula (1) is a divalent group having an alicyclic skeleton, a fluorene skeleton, or an indene skeleton represented by any of the following formulas (2-1), (2-2), and (2-3): 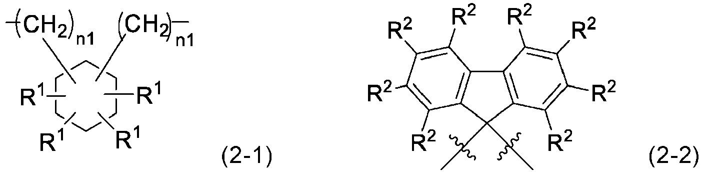 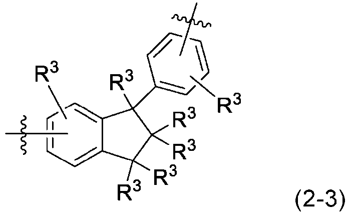 wherein each R¹ independently represents a hydrogen atom or an alkyl group having 1 to 5 carbon atoms, each n1 independently represents an integer of from 0 to 4, each R² and each R³ independently represent a hydrogen atom, an alkyl group having 1 to 5 carbon atoms, a (hetero)aryl group having 4 to 10 carbon atoms, a hydroxy group, an organooxy group, a halogeno group, a trifluoromethyl group, an amino group, or a sulfenyl group.

5. The curable resin composition for solder resist use according to claim 1, wherein A in the formula (1) is a tetravalent organic group represented by any of the following formulas: 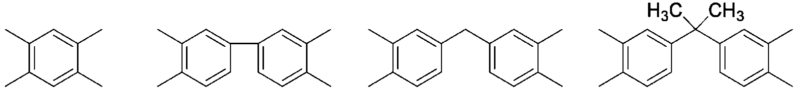 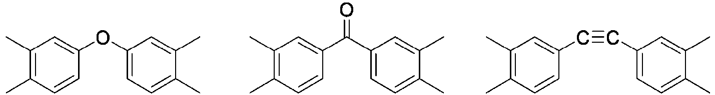 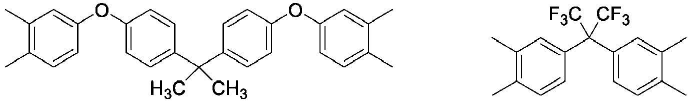 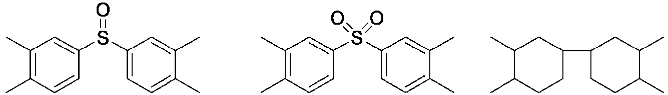 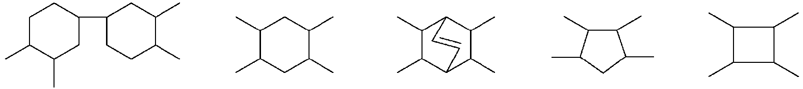 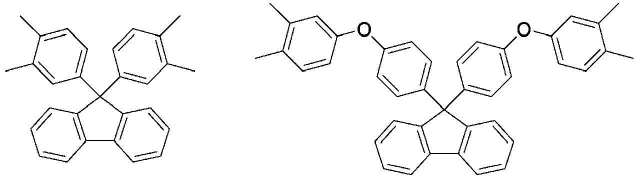 wherein, in the above formulas, each bond with no substituent bonded thereto is bonded to carbonyl carbon included in a cyclic imide structure in the formula (1).

6. The curable resin composition for solder resist use according to claim 1, wherein the bismaleimide compound represented by the formula (1) has a number average molecular weight of 3,000 to 50,000.

7. The curable resin composition for solder resist use according to claim 1, wherein the citraconimide compound (B) is a biscitraconimide compound represented by formula (3) defined as: 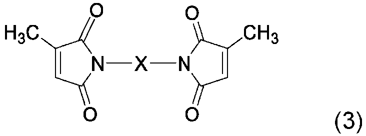 wherein, in the formula (3), X is a divalent organic group.

8. The curable resin composition for solder resist use according to claim 7, wherein X in the formula (3) is selected from a hydrocarbon group derived from a dimer acid skeleton and groups represented by the following structures: 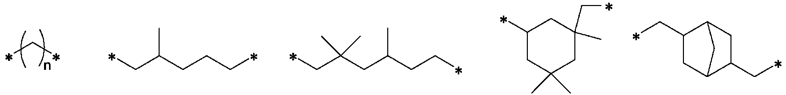 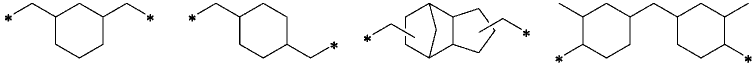 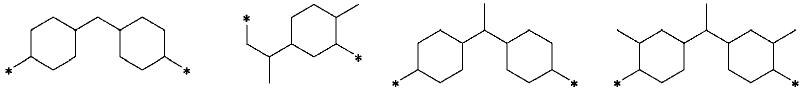 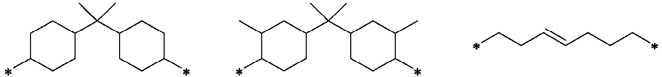 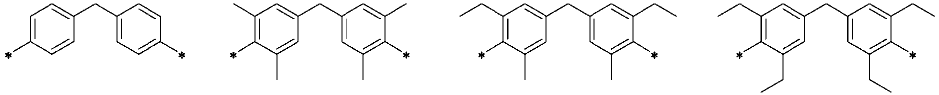 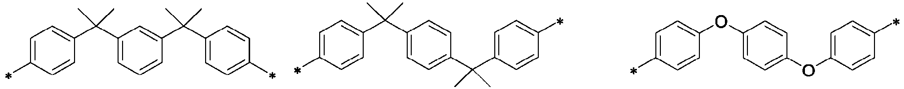 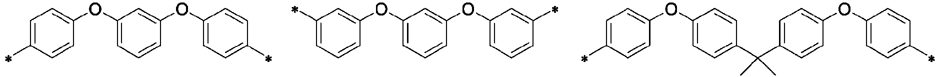 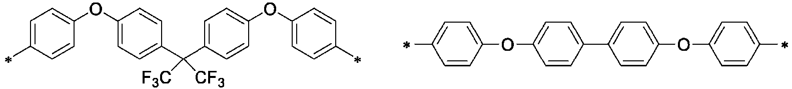 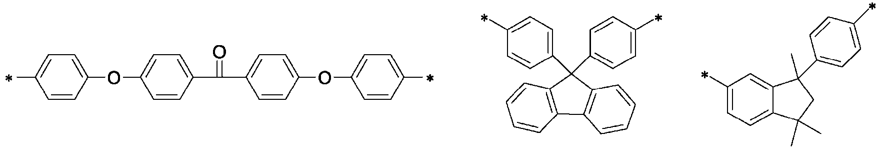 wherein * represents a bond to a nitrogen atom in a citraconimide group, and n is a number of 1 to 20.

9. The curable resin composition for solder resist use according to claim 1, wherein the citraconimide compound (B) has a number average molecular weight of 100 to 5,000.

10. The curable resin composition for solder resist use according to claim 1, wherein the epoxy resin (C) is liquid at 25°C.
